# NEUE EUROPÄISCHE PATENTSCHRIFT

(11) **EP 2 886 605 B2**
(45) Veröffentlichungstag und Bekanntmachung des Hinweises auf die Entscheidung über den Einspruch: **01.09.2021**
(45) Hinweis auf die Patenterteilung: 21.10.2015
(21) Anmeldenummer: 13199124.2
(22) Anmeldetag: 20.12.2013
(51) Int. Cl.: C08L 77/06, C08K 3/22, C08K 3/32, C08K 7/14, C08K 5/5313, C08K 5/3492, C08K 3/24

(54) **Kunststoffformmasse und deren Verwendung**
Plastic moulding material and use of same
Masse de moulage en matière synthétique et son utilisation

(43) Veröffentlichungstag der Anmeldung: 24.06.2015
(73) Patentinhaber: EMS-CHEMIE AG, 7013 Domat/Ems (CH)
(72) Erfinder: Aepli, Etienne, 7013 Domat/Ems (CH)
(74) Vertreter: Bremi, Tobias Hans

(56) Entgegenhaltungen:
- EP-A1- 1 988 113
- EP-A1- 2 028 231
- EP-A1- 2 100 919
- WO-A1-2004/090036
- WO-A1-2006/042830
- WO-A1-2012/056416
- WO-A1-2012/126831
- WO-A2-2011/050934
- US-A1- 2013 289 178
- Prospekt Ultramid T 4381 LDS der BASF, September 2007 (2007-09),
- "Produkte fur innovative Verfahren", Kunststoffe, December 2004 (2004-12), pages 98-102,
- "Abschlussbericht FV Nr 14282N", , December 2006 (2006-12), pages 1-55,

## Beschreibung

### TECHNISCHES GEBIET

Die vorliegende Erfindung betrifft thermoplastische, flammgeschützte Kunststoffformmassen mit verbesserten mechanischen Eigenschaften. Die Formmassen enthalten neben Glasfasern ein Flammschutzmittel sowie ein LDS-Additiv. Daraus hergestellte Formteile sind nach partieller Bestrahlung gezielt metallisierbar. Verwendung finden die erfindungsgemäßen Formmassen insbesondere für die Herstellung von spritzgegossenen Schaltungsträgern.

### STAND DER TECHNIK

Schaltungsträger aus thermoplastischen Kunststoffen haben gegenüber bisherigen Schaltungsträgern den Vorteil der verbesserten Gestaltungsfreiheit, der guten Umweltverträglichkeit und des Rationalisierungspotentials bezüglich des Herstellverfahrens des Endproduktes. Die Integration von elektrischen und mechanischen Funktionen in einem Spritzgussteil kann zu einer Miniaturisierung der Baugruppe führen. Ausserdem können ganz neue Funktionen realisiert und nahezu beliebige Formen gestaltet werden.

Aus der EP-A-1 274 288 ist die sogenannte additive Laser-Strukturierungstechnik bekannt (Laser Direct Structuring, LDS), bei welcher das im Standard-Spritzgiessverfahren hergestellte Formteil mit besonderen Materialeigenschaften, z.B. auf bekeimbarer PBT-Basis, durch einen Laser strukturiert wird. Hierdurch werden auf der Kunststoffoberfläche partiell diejenigen Bereiche, die später die Leitungsbahnen tragen sollen, mit Metallatomen bekeimt, auf denen nachfolgend in chemisch reduktiven Metallisierungsbädern eine Metallschicht wächst. Die Metallkeime entstehen durch Aufbrechen von feinstverteilt im Trägermaterial enthaltenen Metallverbindungen. Nicht bestrahlte Kunststoffbereiche bleiben im Metallisierungsbad unverändert erhalten.

WO-A-2013/076314 beschreibt mit einem Laser direkt strukturierbare thermoplastische Formmassen, die ein auf Zinn und einem weiteren Metall aus einer bestimmten Gruppe basierendes Metallmischoxid als LDS-Additiv enthalten und zeigt anhand von unverstärkten Formmassen aus Polycarbonat oder Polycarbonat-ABS-Mischungen, dass diese Formmassen einen guten Weissgrad besitzen und dass die Metallisierung mit steigendem Anteil an Antimonoxid verbessert werden kann.

WO-A-2012/056416 weist bei unverstärkten und nicht flammgeschützten Polycarbonat/ABS-Blends darauf hin, dass der Zusatz von Titandioxid unabhängig vom Typ des verwendeten LDS-Additivs zu Formmassen mit guten Weissgrad führen kann. WO2009/141799 offenbart laserdirektstrukurierbare Formmassen, die neben dem Flammschutz die weitgehende Beibehaltung der thermisch-mechanischen Eigenschaften, wie z.B. der Wärmeformbeständigkeit, bieten. Wie die Beispiele auf Basis unverstärkter Polycarbonat/ABS-Mischungen und organischer Phosphate zeigen, erreichen die Formmassen die Flammschutzklassifizierung V0 bei 0.8 bzw. 1.6 mm dicken Probenkörpern und die HDT-Werte sämtlicher Proben liegen deutlich unter 100°C.

Aus der US 2013/0289178 sind flammgeschützte LDS-Formmassen auf Basis von Polycarbonat und gegebenenfalls ABS bekannt, die unter bestimmten Bedingungen V0-Klassifizierung erreichen.

### DARSTELLUNG DER ERFINDUNG

Ausgehend hiervon war es Aufgabe der vorliegenden Erfindung, für die MID (Molded Interconnect Devices)-Technik geeignete thermoplastische Kunststoffformassen, insbesondere Polyamidformmassen, und insbesondere solche, die neben Glasfasern auch Flammschutzmittel und LDS-Additive enthalten, bereitzustellen, mit denen Formkörper mit guten mechanischen Eigenschaften, insbesondere mit hoher Steifigkeit, hoher Reissfestigkeit und guter Schlagzähigkeit herstellbar sind, die eine sichere Flammschutzklassifizierung V0 aufweisen und sicher blisterfrei lötbar sind. Darüber hinaus sollen die Formkörper nach Laserbestrahlung gut metallisierbar sein und die Leiterbahnen sollen eine gute Haftung am Polymersubstrat aufweisen.

Die thermischen und mechanischen Eigenschaften sowie die damit verbundenen Einsatzgebiete dieser Schaltungsträger werden in erster Linie durch die zugrundeliegende thermoplastische Formmasse bestimmt. Polyamide sind heutzutage weit verbreitet als Strukturelemente für den Innen- und Außenbereich, was im Wesentlichen auf die hervorragenden (thermo-)mechanischen Eigenschaften, auch unter unterschiedlichen klimatischen Bedingungen, zurückzuführen ist.

Eine Verbesserung der mechanischen Eigenschaften, wie Festigkeit und Steifheit, lässt sich insbesondere durch den Zusatz faserförmiger Verstärkungsstoffe, z.B. Glasfasern oder Carbonfasern, erreichen. In vielen Fällen werden neben den Glasfasern auch noch teilchenförmige Füllstoffe verwendet, sei es, um die Formmassen mittels anorganischer Pigmente einzufärben oder andere spezifische Eigenschaftsmodifizierungen vorzunehmen. Durch den Zusatz von partikulären Füllstoffen, wie z.B. auch den LDS-Additiven oder bestimmten Flammschutzmitteln zu den glasfaserverstärkten Formmassen werden die mechanischen Eigenschaften aber in der Regel deutlich verschlechtert, insbesondere wird die Reissfestigkeit, die Reissdehnung sowie die Schlagzähigkeit normalerweise erheblich reduziert. Weiterhin wird auch die Oberflächengüte insbesondere der Glanz verschlechtert. Durch die spezifische Zusammensetzung der erfindungsgemässen Formmassen wird trotz der Kombination von faserförmigen und partikulären Füllstoffen unerwartet erreicht, dass Formteile hergestellt aus diesen Formmassen neben anderen positiven Eigenschaften gute mechanische Eigenschaften und eine hohe Oberflächengüte aufweisen, sicher im Reflow-Lötprozess lötbar sind und die Brandschutzklassifizierung V0 nach UL94 erreichen. Konkret betrifft die Erfindung eine flammgeschützte Formmasse, insbesondere mit hoher Steifigkeit, Reissfestigkeit und hoher Schlagzähigkeit, nach Anspruch 1.

Bevorzugtermassen liegt dabei der Anteil an Komponente (A) innerhalb der Summe von (A)-(F) im Bereich von 25-75.5 Gew.-%, vorzugsweise im Bereich von 30-71 Gew.-%. Bevorzugtermassen besteht dabei die Komponente (A1) ganz aus teilaromatischem, teilkristallinem Polyamid oder einer Mischung davon mit amorphen Polyamiden oder einer Mischung davon mit aliphatischen Polyamiden, wobei der Anteil an teilaromatischem, teilkristallinem Polyamid jeweils wenigstens 50 Gew.-%, bezogen auf 100 Gew.-% der Komponente (A), beträgt. Bevorzugtermassen besteht die Komponente (A1) zur Hauptsache, das heisst bevorzugtermassen zu 55 bis 100 Gew.-%, insbesondere zu 65 - 100 Gew.-% bezogen auf die Kunststoffmatrix (A), aus teilaromatischem, teilkristallinem Polyamid.

Der Anteil an Komponente (B) liegt bevorzugtermassen im Bereich von 15-60 Gew.-%, vorzugsweise im Bereich von 18-55 oder 18-42 Gew.-% und insbesondere im Bereich von 20-45 Gew.-% oder im Bereich von 20-35 Gew.-%.

Der Anteil an Komponente (C) liegt bevorzugtermassen im Bereich von 0.5-8 Gew.-%, vorzugsweise im Bereich von 1-6 Gew.-% und insbesondere bevorzugt im Bereich von 0.5 - 3.5 Gew.-%.

Die **Komponente (A)** kann aus einem teilaromatischen, teilkristallinen Polyamid (A1) bestehen, oder aber diese in Mischung mit bis zu 45 % thermoplastischem Kunststoff nicht auf Polyamidbasis (A2) enthalten.

Die **Komponente (A2)** kann sowohl ein thermoplastischer Kunststoff nicht auf Polyamidbasis (A2_1) als auch ein davon verschiedener Schlagzähmodifier (A2_2) sein. **Komponente (A2_1)** ist dabei bevorzugtermassen ein thermoplastischer Kunststoff ausgewählt aus der folgenden Gruppe: Polycarbonat, Polyphenylenether, Polystyrol, Polymethylmethacrylat, Acrylnitril-Butadien-Styrol-Copolymerisat, Acrylnitril-Styrol-Copolymer, Polyolefin, Polyoxymethylen, Polyester, insbesondere Polyethylenterephthalat, Polybutylenterephthalat, Polysulfon (insbesondere des Typs PSU, PESU, PPSU), Polyphenylensulfid, flüssigkristalline Polymere, Polyetherketon, Polyetheretherketon, Polyimid, Polyamidimid, Polyesterimid, Polyurethan (insbesondere des Typs TPU, PUR), Polysiloxan, Polyacrylat, Polymethacrylat sowie Mischungen oder Copolymere auf Basis solcher Systeme. Besonders bevorzugt ist Komponente A2_1 ein Polyphenylenether, der nach üblichen Verfahren aus in ortho-Position durch Alkylgruppen disubstituierten Phenolen durch oxidative Kupplung hergestellt (vgl. US-Patente US3661848, US3378505, US3306874, US3306875 und US3639656) wird. Für die Herstellung werden üblicherweise Katalysatoren auf Basis von Schwermetallen wie Kupfer, Mangan oder Kobalt in Kombination mit anderen Substanzen wie sekundären Aminen, tertiären Aminen, Halogenen oder Kombinationen davon benutzt. Geeignete Polyphenylenether sind beispielsweise Poly(2,6-diethyl-1,4-phenylen)ether, Poly(2-methyl-6-ethyl-1,4-phenylen)ether, Poly(2-methyl-6-propyl-1,4-phenylen)ether, Poly(2,6-dipropyl-1,4-phenylen)ether, Poly(2-ethyl-6-propyl-1,4-phenylen)ether oder Copolymere, wie solche, die 2,3,6-Trimethylphenol enthalten, ausserdem Mischungen der genannten Polyphenylenether.

Bevorzugt ist Poly(2,6-dimethyl-1,4-phenylen)ether optional in Kombination mit 2,3,6-Trimethylphenoleinheiten. Die Polyphenylenether können in Form von Homopolymeren, Copolymer, Pfropfcopolymeren, Blockcopolymer oder Ionomeren eingesetzt werden. Geeignete Polyphenylenether weisen im Allgemeinen eine Grenzviskosität im Bereich von 0,1 bis 0,6 dl/g, gemessen in _Chloroform bei 25°C, auf. Dies entspricht einem Molekulargewicht Mₙ (Zahlenmittelwert) von 3'000 bis 40'000 und einem Gewichtsmittelwert des Molekulargewicht Mw von 5'000 bis 80'000. Es ist möglich, eine Kombination eines hochviskosen und eines tiefviskosen Polyphenylenethers einzusetzen. Das Verhältnis der beiden unterschiedlich viskosen Polyphenylenethern hängt von den Viskositäten und den angestrebten physikalischen Eigenschaften ab. Die erfindungsgemässen Mischungen mit dem Polyamid (A1) umfassen bevorzugt 15 bis 40 Gew.-% Polyphenylenether. Für eine bessere Verträglichkeit werden Verträglichkeitsvermittler in Form von polyfunktionellen Verbindungen eingesetzt, die mit dem Polyphenylenether, dem Polyamid oder mit beiden wechselwirken. Die Wechselwirkung kann chemisch (z.B. durch Pfropfung) und/_oder physikalisch (z.B. durch Beeinflussung der Oberflächeneigenschaften der dispersen Phase) sein. Bevorzugtermassen verfügt die Komponente (A2) über Bestandteile mit Säureanhydridgruppen, die durch thermische oder radikalische Reaktion des Hauptkettenpolymers mit einem ungesättigten Dicarbonsäureanhydrid, einer ungesättigten Dicarbonsäure oder einem ungesättigten Dicarbonsäuremonoalkylester in einer Konzentration eingebracht werden, die für eine gute Anbindung an das Polyamid ausreicht, wobei dafür Reagenzien ausgewählt aus der folgenden Gruppe bevorzugtermassen eingesetzt werden: Maleinsäure, Maleinsäureanhydrid, Maleinsäuremonobutylester, Fumarsäure, Aconitsäure und/oder Itaconsäureanhydrid.

Vorzugsweise werden 0.1 bis 4.0 Gew.-% eines ungesättigten Anhydrids an die Schlagzähkomponente als Bestandteil von (A2) aufgepfropft oder das ungesättigte Dicarbonsäureanhydrid oder dessen Vorstufe wird zusammen mit einem weiteren ungesättigten Monomeren aufgepfropft. Generell ist der Pfropfgrad bevorzugtermassen in einem Bereich von 0.1-1.0%, insbesondere bevorzugt in einem Bereich von 0.3-0.8%. Besonders bevorzugt werden Maleinsäureanhydrid gepfropfte Polyphenylenether eingesetzt.

Solche Systeme A2_1 können dabei weiterhin bevorzugt in Kombination mit den unten angegebenen Schlagzähmodifikatoren A2_2, einer bevorzugten Ausführungsform von Komponente A2, eingesetzt werden.

In einer weiteren Ausführungsform enthält die erfindungsgemässe Formmasse als **Komponente (A2_2)** bis zu 45 Gew.-% eines oder mehrerer Schlagzähmodifikatoren (SZM). Werden die Komponenten A2_1 und A2_2 zusammen verwendet, beträgt das Verhältnis A2_1 : A2_2 wenigstens 1:1, bevorzugt 1.2:1, besonders bevorzugt 1.5:1 und liegt damit im Bereich von 1:1 bis 1:10, bevorzugt im Bereich von 1.2:1 bis 1:10, besonders bevorzugt im Bereich von 1.5:1 bis 1:8.

Bevorzugt wird eine SZM-Konzentration im Bereich zwischen 5 und 45 Gew.-%, insbesondere von 5-30 Gew.-%. Der Schlagzähmodifier kann ein Naturkautschuk, Polybutadien, Polyisopren, Polyisobutylen, ein Mischpolymerisat des Butadiens und/oder Isoprens mit Styrol oder Styrolderivaten und anderen Comonomeren, ein hydriertes Mischpolymerisat und oder ein Mischpolymerisat, das durch Pfropfen oder Copolymerisation mit Säureanhydriden, (Meth)acrylsäure und deren Ester entstanden ist, sein. Der Schlagzähmodifier (A2_2) kann auch ein Pfropfkautschuk mit einem vernetzten elastomeren Kern, der aus Butadien, Isopren oder Alkylacrylaten besteht und eine Pfropfhülle aus Polystyrol hat, ein unpolares oder polares Olefinhomo- und copolymeres wie Ethylen-Propylen-, Ethylen-Propylen-Dien- und Ethylen-Octen- oder Ethylen-Vinylacteat-Kautschuk oder ein unpolares oder polares Olefinhomo- und copolymeres, das durch Pfropfen oder Copolymerisation mit Säureanhydriden, (Meth)acrylsäure und deren Ester entstanden ist, sein. Der Schlagzähmodifier (A2_2) kann auch ein carbonsäurefunktionalisiertes Copolymeres wie Poly(ethen-co-(meth)acrylsäure) oder Poly(ethen-co-1-olefin-co-(meth)acrylsäure) sein, wobei das 1-Olefin ein Alken oder ein ungesättigter (Meth)acrylsäureester mit mehr als 4 Atomen sein kann, einschliesslich solchen Copolymeren, in denen die Säuregruppen teilweise mit Metallionen neutralisiert sind. Bevorzugte Schlagzähmodifikatoren der Komponente (A2_2) auf Basis von Styrolmonomeren (Styrol und Styrolderivate) und anderen vinylaromatischen Monomeren sind Blockcopolymere aufgebaut aus alkenylaromatischen Verbindungen und einem konjungierten Dien, sowie hydrierte Blockcopolymere aus einer alkenylaromatischen Verbindung und konjungierten Dienen oder Kombinationen dieser SZM-Typen. Das Blockcopolymer enthält mindestens einen Block abgeleitet von einer alkenylaromatischen Verbindung (A) und wenigstens einem Block abgeleitet von einem konjungierten Dien (B). Bei den hydrierten Blockcopolymeren wurde der Anteil an aliphatisch ungesättigten Kohlenstoff-Kohlenstoff-Doppelbindungen durch Hydrierung reduziert. Als Blockcopolymere sind Zwei-, Drei-, Vier- und Polyblockcopolymere mit linearer Struktur geeignet. Jedoch sind verzweigte und sternförmige Strukturen ebenfalls einsetzbar. Verzweigte Blockcopolymere erhält man in bekannter Weise, z.B. durch Pfropfreaktionen von polymeren "Seitenästen" auf eine Polymer-Hauptkette. Als alkenylaromatische Monomere können neben oder in Mischung mit Styrol, auch vinylaromatische Monomere verwendet werden, die am aromatischen Ring und/oder an der C=C-Doppelbindung mit C1-20-Kohlenwasserstoffresten oder Halogenatomen substituiert sind.

Beispiele für alkenylaromatische Monomere sind Styrol, p-Methylstyrol, α-Methylstyrol, Ethylstyrol, tert.-Butylstyrol, Vinyltoluol, 1,2-Diphenylethylen, 1,1-Diphenylethylen, Vinylxylole, Vinyltoluole, Vinylnaphthaline, Divinylbenzole, Bromstyrole, Chlorstyrole, sowie Kombinationen davon. Bevorzugt werden Styrol, p-Methylstyrol, alpha-Methylstyrol und Vinylnaphthalin.

Als Dienmonomere kommen z.B. 1,3-Butadien, 2-Methyl-1,3-butadien, 2,3-Dimethyl-1,3-butadien, 1,3-Pentadien, 1,3-Hexadien, Isopren, Chloropren und Piperylen in Betracht. 1,3-Butadien und Isopren sind bevorzugt, insbesondere 1,3-Butadien (nachfolgend kurz als Butadien bezeichnet).

Bevorzugt verwendet man als alkenylaromatisches Monomer Styrol und als Dienmonomer Butadien, d.h. bevorzugt ist das Styrol-Butadien-Blockcopolymer. In der Regel werden die Blockcopolymere durch anionische Polymerisation in an sich bekannter Weise hergestellt. Weiterhin kann man zusätzlich zu den Styrol- und Dienmonomeren weitere Comonomere mitverwenden. Der Anteil der Comonomeren beträgt bevorzugt 0 bis 50, besonders bevorzugt 0 bis 30 und insbesondere 0 bis 15 Gew.-%, bezogen auf die Gesamtmenge der eingesetzten Monomeren. Geeignete Comonomere sind z.B. Acrylate, insbesondere C1-12-Alkylacrylate wie n-Butylacrylat oder 2-Ethylhexylacrylat, und die entsprechenden Methacrylate, insbesondere C1-12-Alkylmethacrylate wie Methylmethacrylat (MMA). Weitere mögliche Comonomere sind (Meth)acrylnitril, Glycidyl(meth)acrylat, Vinylmethylether, Diallyl- und Divinylether bifunktioneller Alkohole, Divinylbenzol und Vinylacetat.

Zusätzlich zum konjugierten Dien enthalten die hydrierten Blockcopolymere der Komponente (A2) gegebenenfalls noch Anteile an niederen Kohlenwasserstoffen wie z.B. Ethylen, Propylen, 1-Buten, Dicyclopentadien oder nicht-konjugierte Diene. In den hydrierten Blockcopolymeren ist der Anteil der nicht reduzierten aliphatischen ungesättigten Bindungen, die aus dem Block B resultieren, kleiner 50%, bevorzugt kleiner 25%, insbesondere kleiner 10%. Die aromatischen Anteile aus Block A werden maximal zu 25% reduziert. Die hydrierten Blockcopolymere Styrol-(ethylen-butylen)-Zweiblock und Styrol-(ethylen-butylen)-styrol-Dreiblock-Copolymere werden durch Hydrierung von Styrol-butadien- und Styrol-butadien-styrol-Copolymeren erhalten. Die Blockcopolymere bestehen bevorzugt zu 20 bis 90 Gew.-% aus Block A, insbesondere zu 50 bis 85 Gew.-% aus Block A. Das Dien kann in 1,2- oder in 1,4-Orientierungen in den Block B eingebaut werden.

Beispiele für nicht-hydrierte Blockcopolymere sind Polystyrol-polybutadien, Polystyrol-poly(ethyen-propylen), Polystyrol-polyisopren, Poly(α-methyl-styrol)-polybutadien, Polystyrene-polybutadien-polystyrol (SBS), Polystyrol-Poly(ethylene-propylen)-polystyrol, Polystyrol-polyisopren-polystyrol und Poly(α-methylstyrol-polybutadiene-poly(α-methylstyrol), als auch Kombinationen davon.

Geeignete nicht-hydrierte Blockcopolymere, die kommerziell erhältlich sind, sind verschiedene Produkte mit dem Markennamen SOLPRENE® (Phillips), KRATON® (Shell), VECTOR® (Dexco) und SEPTON® (Kuraray).

Gemäss einer weiteren bevorzugten Ausführungsform sind die erfindungsgemässen Formmassen dadurch gekennzeichnet, dass die Komponente (A2_2) ein Polyolefinhomopolymeres oder ein Ethylen-α-Olefin-Copolymeres, insbesondere bevorzugt ein EP- und/oder EPDM-Elastomer (Ethylen-Propylen-Kautschuk respektive Ethylen-Propylen-Dien-Kautschuk), enthält. So kann es sich beispielsweise um ein Elastomer handeln, welches basiert auf einem Ethylen-C3-12- α -Olefin-Copolymer mit 20 bis 96, bevorzugt 25 bis 85 Gew.-% Ethylen, wobei es sich insbesondere bevorzugt bei dem C3-12-α-Olefin um ein Olefin ausgewählt aus der Gruppe Propen, 1-Buten, 1-Penten, 1-Hexen, 1-Octen, 1-Decen und/oder 1-Dodecen handelt, und es sich insbesondere bevorzugt bei der Komponente C um Ethylen-Propylen-Kautschuk und/oder LLDPE und/oder VLDPE handelt.

Alternativ oder zusätzlich (beispielsweise in Mischung) kann (A2) ein Terpolymeres auf Basis von Ethylen-C3-12-α-Olefin mit einem unkonjugierten Dien enthalten, wobei dieses bevorzugtermassen 25 bis 85 Gew.-% Ethylen und bis maximal im Bereich von 10 Gew.-% eines unkonjugierten Diens enthält, wobei es sich insbesondere bevorzugt bei dem C3-12-α-Olefin um ein Olefin ausgewählt aus der Gruppe Propen, 1-Buten, 1-Penten, 1-Hexen, 1-Octen, 1-Decen und/oder 1-Dodecen handelt, und/oder wobei das unkonjugierte Dien bevorzugt ausgewählt ist aus der Gruppe Bicyclo(2.2.1) heptadien, Hexadien-1.4, Dicyclopentadien und/oder insbesondere 5-Ethylidennorbornen.

In Frage als Bestandteil für die Komponente (A2_2) kommen zudem auch Ethylen-Acrylat-Copolymere. Weitere mögliche Formen als Bestandteile für die Komponente (A2_2) sind die Ethylen-Butylen-Copolymere beziehungsweise Mischungen (Blends), welche derartige Systeme enthalten.

Bevorzugtermassen verfügt die Komponente (A2_2) über Bestandteile mit Säureanhydridgruppen, die durch thermische oder radikalische Reaktion des Hauptkettenpolymers mit einem ungesättigten Dicarbonsäureanhydrid, einer ungesättigten Dicarbonsäure oder einem ungesättigten Dicarbonsäuremonoalkylester in einer Konzentration eingebracht werden, die für eine gute Anbindung an das Polyamid ausreicht, wobei dafür Reagenzien ausgewählt aus der folgenden Gruppe bevorzugtermassen eingesetzt werden: Maleinsäure, Maleinsäureanhydrid, Maleinsäuremonobutylester, Fumarsäure, Aconitsäure und/oder Itaconsäureanhydrid.

Vorzugsweise werden 0.1 bis 4.0 Gew.-% eines ungesättigten Anhydrids an die Schlagzähkomponente als Bestandteil von (A2_2) aufgepfropft oder das ungesättigte Dicarbonsäureanhydrid oder dessen Vorstufe wird zusammen mit einem weiteren ungesättigten Monomeren aufgepfropft. Generell ist der Pfropfgrad bevorzugtermassen in einem Bereich von 0.1-1.0%, insbesondere bevorzugt in einem Bereich von 0.3-0.7%. Auch möglich als Bestandteil der Komponente (A2_2) ist eine Mischung aus einem Ethylen-Propylen-Copolymer und einem Ethylen-Butylen-Copolymer, dies mit einem Maleinsäureanhydrid-Pfropfgrad (MAH-Propfgrad) im Bereich von 0.3-0.7%. Die oben angegebenen möglichen Systeme für die Komponente können auch in Mischungen verwendet werden.

Weiterhin kann die Komponente (A2_2) über Bestandteile verfügen, welche über funktionelle Gruppen, wie z.B. Carbonsäure-, Ester-, Epoxy-, Oxazolin-, Carbodiimid-, Isocyanat-, Silanol- und Carboxylat-Gruppen verfügen, oder Kombinationen von zwei oder mehrerer der genannten funktionellen Gruppen enthalten. Monomere, die diese funktionellen Gruppen tragen, können durch Co-Polymerisation oder Pfropfung an das elastomere Polyolefin gebunden werden. Ausserdem können die SZM auf Basis der Olefinpolymere auch durch Pfropfung mit einer ungesättigten Silanverbindung, z. B. Vinyltrimethoxysilan, Vinyltriethoxysilan, Vinyltriacetosilan, Methacryloxypropyltrimethoxysilan oder Propenyltrimethoxysilan modifiziert sein.

Die elastomeren Polyolefine sind statistische, alternierende oder segmentierte Copolymere mit linearer, verzweigter oder Core-Shell-Struktur und enthalten funktionelle Gruppen, die mit den Endgruppen der Polyamide reagieren können, so dass eine ausreichende Verträglichkeit zwischen Polyamid und SZM resultiert.

Die als Komponente (A2_2) eingesetzten SZM schliessen damit Homopolymere oder Copolymere von Olefinen, wie z.B. Ethylen, Propylen, Buten-1, oder Copolymere von Olefinen und copolymerisierbaren Monomeren, wie Vinylacetat, (Meth)acrylsäureester und Methylhexadien, ein.

Besonders bevorzugt werden folgende Olefinpolymere: Niedrig-, mittel- und hochdichte Polyethylene, Polypropylen, Polybutadien, Poly-4-methylpenten, Ethylen-Propylen-Block- oder statistische Copolymere, Ethylen-Methylhexadien-Copolymere, Propylen-Methylhexadien-Copolymere, Ethylen-Propylen-Buten-Copolymere, Ethylen-Propylen-Hexen-Copolymere, Ethylen-Propylen-Methylhexadien-Copolymere, Poly(ethylenvinylacetat) (EVA), Poly(ethylen-ethylacrylat) (EEA), Ethylen-Octen-Copolymer, Ethylen-Buten-Copolymer, Ethylen-Hexen-Copolymer, Ethylen-Propylen-Dien-Terpolymere sowie Kombinationen der genannten Polymere. Insbesondere ist bevorzugt, wenn diese Olefinpolymere mit Säureanhydridgruppen funktionalisiert sind.

Beispiele für kommerziell erhältliche Schlagzähmodifier, welche im Rahmen der Bestandteile der Komponente (A2_2) eingesetzt werden können, sind: TAFMER MC201, TAFMER MH5010, TAFMER MH7010, TAFMER MH7020 von Mitsui Chemicals; EXXELOR VA1801, EXXELOR VA1803, EXXELOR VA1810, EXXELOR MDEX 94-11, Exxon Mobile Chemical; FUSABOND MN493D, FUSABOND A EB560D; ELVALOY, DuPont.

Bevorzugt wird auch ein Ionomer im Rahmen von Komponente (A2), in welchem die polymergebundenen Carboxylgruppen ganz oder teilweise durch Metallionen miteinander verbunden sind.

Besonders bevorzugt sind durch Pfropfen mit Maleinsäureanhydrid funktionalisierte Mischpolymerisate des Butadiens mit Styrol, unpolare oder polare Olefinhomo- und Copolymere, die durch Pfropfen mit Maleinsäureanhydrid entstanden sind und carbonsäurefunktionalisierte Copolymere wie Poly(ethen-co-(meth)arylsäure) oder Poly(ethen-co-1-olefin-co-(meth)acrylsäure), in denen die Säuregruppen teilweise mit Metallionen neutralisiert sind.

Die erfindungsgemässe Formmasse besteht bevorzugt aus 21 bis 81 Gew.-% aus einer thermoplastischen Kunststoffmischung (A) bestehend aus **Polyamid (A1)** und einem thermoplastischen Kunststoff (A2) nicht auf Polyamidbasis, wobei die Konzentration von (A2) höchstens 45 Gew.-% bezogen auf die Mischung A ausmacht. Die Komponente A1 besteht dabei bevorzugt aus 50 - 100 Gew.-% teilaromatischem, teilkristallinem Polyamid. Insbesondere ist Komponente (A1) eine Mischung aus teilaromatischen, teilkristallinen Polyamiden (Komponente A1_1) und amorphen, teilaromatischen Polyamiden (Komponente A1_2) und/oder aliphatischen Polyamiden (A1_3), wobei der Anteil an teilaromatischen teilkristallinen Polyamiden A1_1 wenigstens 50 Gew.-%, bevorzugt wenigstens 60 Gew.-% und besonders bevorzugt wenigstens 65 Gew.-% beträgt. Die Konzentration von Komponente (A1_2) oder (A1_3) oder die Summe aus (A1_2) und (A1_3) liegt dabei im Bereich von 5-50 Gew.-%, bevorzugt im Bereich von 10-40 Gew.-% und besonders bevorzugt im Bereich von 10-35 Gew.-%.

Die Polyamide A1_1, A1_2 oder A1_3 haben vorzugsweise eine Lösungsviskosität ηᵣₑₗ, gemessen in m-Kresol (0,5 Gew.-%, 20°C) im Bereich von 1,4 bis 3.0, bevorzugt im Bereich von 1,5 bis 2.7, insbesondere im Bereich von 1,5 bis 2.4.

Bei der **Komponente (A1_1)** handelt es sich um teilkristalline, teilaromatische Polyamide, welche bevorzugtermassen eine Glasübergangstemperatur im Bereich von 90 bis 140°C, bevorzugt im Bereich von 110 bis 140°C und insbesondere im Bereich von 115 bis 135°C besitzen. Der Schmelzpunkt des Polyamids (A1_1) liegt im Bereich von 255 bis 330°C, bevorzugt im Bereich von 270 bis 325°C und insbesondere im Bereich von 280 bis 320 °C. Bevorzugt verfügen die teilkristallinen, teilaromatischen Polyamide der Komponente (A1) über mittels DSC bestimmte Schmelzenthalpien (ISO-Norm 11357-11-2) im Bereich von 25 bis 80 J/g, vorzugsweise im Bereich von 30 bis 70 J/g.

Bevorzugte teilaromatische teilkristalline Polyamide sind dabei aus
a) 30 bis 100 mol-%, insbesondere 50 bis 100 mol-% Terephthalsäure und/oder Naphthalindicarbonsäure sowie 0 bis 70 mol-%, insbesondere 0 bis 50 mol-% mindestens einer aliphatischen Dicarbonsäure mit 6 bis 12 Kohlenstoffatomen, und/oder 0 bis 70 mol-%, insbesondere 0 bis 50 mol-% mindestens einer cycloaliphatischen Dicarbonsäure mit 8 bis 20 Kohlenstoffatomen, und/oder 0 bis 50 mol-% Isophthalsäure, bezogen auf die Gesamtmenge der Dicarbonsäuren,
b) 80 bis 100 mol-% mindestens eines aliphatischen Diamins mit 4-18 Kohlenstoffatomen, vorzugsweise mit 6 bis 12 Kohlenstoffatomen sowie 0 bis 20 mol-% mindestens eines cycloaliphatischen Diamins, vorzugsweise mit 6 bis 20 Kohlenstoffatomen, wie z.B. PACM, MACM, IPDA und/oder 0 bis 20 mol-% mindestens eines araliphatischen Diamins, wie z.B. MXDA und PXDA, bezogen auf die Gesamtmenge der Diamine, sowie gegebenenfalls
c) Aminocarbonsäuren und/oder Lactamen je mit 6 bis 12 Kohlenstoffatomen, hergestellt. Gemäß einer bevorzugten Ausführungsform wird dabei das teilaromatische Polyamid der Komponente (A1_1) auf Basis von wenigstens 55 Mol-%, insbesondere von wenigstens 65 Mol-% Terephthalsäure und wenigstens 80 Mol-%, bevorzugt wenigstens 90 Mol-%, insbesondere wenigstens 95 Mol-% aliphatischen Diaminen mit 4 bis 18 Kohlenstoffatomen, vorzugsweise mit 6-12 Kohlenstoffatomen, und gegebenenfalls weiteren aliphatischen, cycloaliphatischen und aromatischen Dicarbonsäuren sowie Lactamen und/oder Aminocarbonsäuren, gebildet. Als weitere aromatische Dicarbonsäuren können neben der Terephthalsäure Isophthalsäure und Naphthalindicarbonsäure verwendet werden. Geeignete aliphatische und cycloaliphatische Dicarbonsäuren, die neben Terephthalsäure verwendet werden können, besitzen 6 bis 36 Kohlenstoffatome und werden in einem Anteil von höchstens 70 Mol-%, insbesondere in einem Anteil von höchstens 50 Mol-%, bezogen auf die Gesamtmenge der Dicarbonsäuren, eingesetzt. Zudem ist bevorzugt, dass die genannten aromatischen Dicarbonsäuren des teilaromatischen Polyamids der Komponente (A1_1) ausgewählt sind aus der Gruppe: Terephthalsäure, Isophthalsäure, sowie Mischungen davon.

Gemäß einer weiteren bevorzugten Ausführungsform sind die genannten z.B. aliphatischen Dicarbonsäuren des teilaromatischen Polyamids der Komponente (A1_1), die neben Terephthalsäure eingesetzt werden können, ausgewählt aus der Gruppe Adipinsäure, Korksäure, Azelainsäure, Sebazinsäure, Undecandisäure, Dodecandisäure, Brassylsäure, Tetradecandisäure, Pentadecandisäure, Hexadecandisäure, Octadecandisäure und Dimerfettsäure (C36). Besonders bevorzugt werden Adipinsäure, Sebazinsäure und Dodecandisäure. Dicarbonsäuren die neben Terephthalsäure bevorzugt eingesetzt werden sind demnach: Isophthalsäure, Adipinsäure, Sebazinsäure und Dodecandisäure oder eine Mischung derartiger Dicarbonsäuren. Insbesondere wird werden Polyamide A1_1 bevorzugt, die ausschliesslich auf Terephthalsäure als Dicarbonsäure beruhen.

Gemäß einer weiteren bevorzugten Ausführungsform sind die genannten aliphatischen Diamine des teilaromatischen Polyamids der Komponente (A1_1) ausgewählt aus der Gruppe 1,4-Butandiamin, 1,5-Pentandiamin, 1,6-Hexandiamin, 1,7-Heptandiamin, 1,8-Octandiamin, 1,9-Nonandiamin, Methyl-1,8-Octandiamin, 1,10-Decandiamin, 1,11-Undecandiamin, 1,12-Dodecandiamin, oder einer Mischung derartiger Diamine, wobei 1,6-Hexandiamin, 1,10-Decandiamin, 1,12-Dodecandiamin, oder eine Mischung derartiger Diamine bevorzugt ist, wobei 1,6-Hexandiamin und 1,10-Decandiamin besonders bevorzugt sind. Neben den aliphatischen Diaminen können in einer Konzentration von 0 bis 20 Mol-%, bezogen auf die Gesamtmenge an Diaminen, cycloaliphatische und/oder araliphatische Diamine ersetzt werden. Besonders bevorzugt werden die hochschmelzenden Polyamide aus folgenden Komponenten gebildet:
a) (A1_1a) Dicarbonsäuren: 50 - 100 Mol-% aromatische Terephthalsäure und/oder Naphthalindicarbonsäure, bezogen auf den Gesamtgehalt an anwesenden Dicarbonsäuren, 0 - 50 Mol-% einer aliphatischen Dicarbonsäure, bevorzugt mit 6 bis 12 Kohlenstoffatomen, und/oder einer cycloaliphatischen Dicarbonsäure mit bevorzugt 8 bis 20 Kohlenstoffatomen, und/oder Isophthalsäure;
b) (A1_1b) Diamine: 80 - 100 Mol-% mindestens eines aliphatischen Diamins mit 4-18 Kohlenstoffatomen, vorzugsweise mit 6 bis 12 Kohlenstoffatomen, bezogen auf den Gesamtgehalt an anwesenden Diaminen, 0 - 20 Mol-% cycloaliphatische Diamine, vorzugsweise mit 6 bis 20 Kohlenstoffatomen, wie z.B. PACM, MACM, IP-DA und/oder araliphatische Diamine, wie z.B. MXDA und PXDA, wobei in den hochschmelzenden Polyamiden der prozentuale Molgehalt an Dicarbonsäuren 100 % und der prozentuale Molgehalt an Diaminen 100 % ausmacht, und gegebenenfalls aus:
c) (A1_1c) Aminocarbonsäuren und/oder Lactamen, enthaltend Lactame mit bevorzugt 6 bis 12 Kohlenstoffatomen, und/oder Aminocarbonsäuren mit bevorzugt 6 bis 12 Kohlenstoffatomen.

Während die Komponenten (A1_1a) und (A1_1b) weitgehend äquimolar eingesetzt werden, beträgt die Konzentration von (A1_1c) vorzugsweise höchstens 20 Gew.-%, bevorzugt höchstens 15 Gew.-%, insbesondere höchstens 12 Gew.-%, jeweils bezogen auf die Summe von (A1_1a) bis (A1_1c).

Zusätzlich zu den weitgehend äquimolar eingesetzten Komponenten (A1_1a) und (A1_1b) können Dicarbonsäuren (A1_1a) oder Diamine (A1_1b) zur Regelung der Molmasse oder zum Ausgleich von Monomerverlusten bei der Polyamidherstellung eingesetzt werden, sodass in ihrer Gesamtheit die Konzentration einer Komponente (A1_1a) oder (A1_1b) überwiegen kann.

Geeignete cycloaliphatische Dicarbonsäuren sind die cis- und/oder trans-Cyclohexan-1,4-dicarbonsäure und/oder cis- und/oder trans-Cyclohexan-1,3-dicarbonsäure (CHDA).

Die oben genannten, in der Regel eingesetzten aliphatischen Diamine können in untergeordneter Menge von nicht mehr als 20 Mol-%, von vorzugsweise nicht mehr als 15 Mol-% und insbesondere nicht mehr als 10 Mol-%, bezogen auf die Gesamtmenge der Diamine, durch andere Diamine ersetzt werden. Als cycloaliphatische Diamine können beispielsweise Cyclohexandiamin, 1,3-Bis-(aminomethyl)-cyclohexan (BAC), Isophorondiamin, Norbornandimethylamin, 4,4'-Diaminodicyclohexylmethan (PACM), 2,2-(4,4'-Diaminodicyclohexyl)propan (PACP) und 3,3'-Dimethyl-4,4'-diaminodicyclohexylmethan (MACM) verwendet werden. Als araliphatische Diamine seien m-Xylylendiamin (MXDA) und p-Xylylendiamin (PXDA) erwähnt.

Zusätzlich zu den beschriebenen Dicarbonsäuren und Diaminen können noch Lactame und/oder Aminocarbonsäuren als polyamidbildende Komponenten (Komponente (A1c)) eingesetzt werden. Geeignete Verbindungen sind beispielsweise Caprolactam (CL), α,ω-Aminocapronsäure, α,ω-Aminononansäure, α,ω-Aminoundecansäure (AUA), Laurinlactam (LL) und α,ω-Aminododecansäure (ADA). Die Konzentration der zusammen mit den Komponenten (A1a) und (A1b) eingesetzten Aminocarbonsäuren und/oder Lactame beträgt höchstens 20 Gew.-%, bevorzugt höchstens 15 Gew.-% und besonders bevorzugt höchstens 12 Gew.-%, bezogen auf die Summe der Komponenten (A1a) bis (A1c). Speziell bevorzugt sind Lactame bzw. α,ω-Aminosäuren mit 4, 6, 7, 8, 11 oder 12 C-Atomen. Dies sind die Lactame Pyrrolidin-2-on (4 C-Atome), s-Caprolactam (6 C-Atome), Önanthlactam (7 C-Atome), Capryllactam (8 C-Atome), Laurinlactam (12 C-Atome) bzw. die α,ω-Aminosäuren 1,4-Aminobutansäure, 1,6-Aminohexansäure, 1,7-Aminoheptansäure, 1,8-Aminooctansäure, 1,11-Aminoundecansäure und 1,12-Aminododecansäure. In einer besonders bevorzugten Ausführungsform ist Komponente A1_1 frei von Caprolactam bzw. Aminocapronsäure.

Zur Regelung der Molmasse, der relativen Viskosität bzw. der Fliessfähigkeit oder des MVR können dem Ansatz und/oder dem Vorkondensat (vor der Nachkondensation) Regler in Form von Monocarbonsäuren oder Monoaminen zugesetzt werden. Als Regler geeignete, aliphatische, cycloaliphatische oder aromatische Monocarbonsäuren oder Monoamine sind Essigsäure, Propionsäure, Buttersäure, Valeriansäure, Capronsäure, Laurinsäure, Stearinsäure, 2-Ethylhexansäure, Cyclohexansäure, Benzoesäure, 3-(3,5-di-tert-butyl-4-hydroxyphenyl)propansäure, 3,5-di-tert-butyl-4-hydroxybenzoesäure, 3-(3-tert-butyl-4-hydroxy-5-methylphenyl)propansäure, 2-(3,5-di-tert-butyl-4-hydroxybenzylthio)essigsäure, 3,3-bis(3-tert-butyl-4-hydroxyphenyl)butansäure, Butylamin, Pentylamin, Hexylamin, 2-Ethylhexylamin, n-Octylamin, n-Dodecylamin, n-Tetradecylamin, n-Hexadecylamin, Stearylamin, Cyclohexylamin, 3-(Cyclohexylamino)-propylamin, Methylcyclohexylamin, Dimethylcyclohexylamin, Benzylamin, 2-Phenylethylamin, 2,2,6,6-tetramethylpiperidin-4-amin, 1,2,2,6,6-pentamethylpiperidin-4-amin, 4-amino-2,6-di-tert-butylphenol. Die Regler können einzeln oder in Kombination benutzt werden. Es können auch andere monofunktionelle Verbindungen als Regler eingesetzt werden, die mit einer Amino- oder Säuregruppe reagieren können, wie Anhydride, Isocyanate, Säurehalogenide oder Ester. Die übliche Einsatzmenge der Regler liegt zwischen 10 und 200 mmol pro kg Polymer.

Die teilaromatischen Copolyamide (A1_1) können mit an sich bekannten Verfahren hergestellt werden. Geeignete Verfahren sind an verschiedener Stelle beschrieben worden, und in der Folge sollen einige der möglichen in der Patentliteratur diskutierten Verfahren angegeben werden, der Offenbarungsgehalt der nachfolgend genannten Dokumente wird hinsichtlich des Verfahrens zur Herstellung des Polyamids der Komponente (A_1) der vorliegenden Erfindung ausdrücklich in den Offenbarungsgehalt der vorliegenden Anmeldung eingeschlossen: DE-A-195 13 940, EP-A-0 976 774, EP-A-0 129 195, EP-A-0 129 196, EP-A-0 299 444, US 4,831,106, US 4,607,073, DE-A-14 95 393 und US 3,454,536.

Konkrete Vertreter für die erfindungsgemäßen Polyamide (A1_1) sind: PA 4T/4I, PA 4T/6I, PA 5T/5I, PA 6T/6, PA 6T/6I, PA 6T/6I/6, PA 6T/66, 6T/610, 6T/612, PA 6T/10T, PA 6T/10I, PA 9T, PA 10T, PA 12T, PA 10T/10I, PA10T/106, PA10T/12, PA10T/11, PA 6T/9T, PA 6T/12T, PA 6T/10T/6I, PA 6T/6I/6, PA 6T/6I/12 sowie Mischungen davon, insbesondere vorzugsweise ist das teilaromatische Polyamid der Komponente (A_1) ausgewählt aus der Gruppe: PA 6T/6I, PA 6T/10T, PA 6T/10T/6I, sowie Mischungen davon. Bevorzugt werden Polyamide (A1_1), welche 6T-Einheiten, insbesondere wenigstens 10 Gew.-% an 6T-Einheiten enthalten.

Erfindungsgemäß sind daher als hochschmelzende Polyamide (A1_1) insbesondere folgende teilaromatische Copolyamide bevorzugt:
- teilkristallines Polyamid 6T/6I mit 55 bis 75 Mol-% Hexamethylenterephthalamid-Einheiten und 25 bis 45 Mol-% Hexamethylenisophthalamid-Einheiten;
- teilkristallines Polyamid 6T/6I mit 62 bis 73 Mol-% Hexamethylenterephthalamid-Einheiten und 25 bis 38 Mol-% Hexamethylenisophthalamid-Einheiten;
- teilkristallines Polyamid 6T/6I mit 70 Mol-% Hexamethylenterephthalamid-Einheiten und 30 Mol-% Hexamethylenisophthalamid-Einheiten;
- teilkristallines Polyamid, hergestellt aus mindestens 50 Mol-% Terephthalsäure und höchstens 50 Mol-% Isophthalsäure, insbesondere aus 100 Mol-% Terephalsäure, sowie einer Mischung aus mindestens zwei Diaminen, ausgewählt aus der Gruppe Hexamethylendiamin, Nonandiamin, Methyloctandiamin und Decandiamin;
- teilkristallines Polyamid, hergestellt aus 70-100 Mol-% Terephthalsäure und 0-30 Mol-% Isophthalsäure sowie einer Mischung aus Hexamethylendiamin und Dodecandiamin;
- teilkristallines Polyamid, hergestellt aus mindestens 50 Mol-% Terephthalsäure und höchstens 50 Mol-% Dodekandisäure sowie einer Mischung aus mindestens zwei Diaminen, ausgewählt aus der Gruppe Hexamethylendiamin, Nonandiamin, Methyloctandiamin und Decandiamin;
- teilkristallines Polyamid 6T/10T mit 10 bis 60 Mol-%, bevorzugt 10 bis 40 Mol-% Hexamethylenterephthalamid-(6T)-und 40 bis 90 Mol-%, bevorzugt 60 bis 90 Mol-% Decamethylenterephthalamid-(10T)-Einheiten;
- teilkristallines Polyamid 6T/10T/6I mit 50 bis 90 Mol-%, vorzugsweise 50-70 Mol-% Hexamethylenterephthalamid-(6T)-, und 5 bis 45 Mol-%, vorzugsweise 10-30 Mol-% Hexamethylenisophthalamid-(6I)-Einheiten und 5 bis 45 Mol-%, vorzugsweise 20-40 Mol-% Decamethylenterephthalamid-(10T)-Einheiten;
- teilkristallines Polyamid 6T/6I/6 mit 60 bis 85 Mol-% Hexamethylenterephthalamid-(6T)- und 15 bis 40 Mol-% Hexamethylenisophthalamid-(6I)-Einheiten, das zusätzlich 5 - 15 Gew.-% Caprolactam enthält.

Das teilaromatische, teilkristalline Polyamid (A1_1) hat eine Lösungsviskosität ηᵣₑₗ, (bestimmt nach DIN EN ISO 307, 0.5 Gew.-% in m-Kresol, 20 °C) von höchstens 2,6, bevorzugt von höchstens 2,3, insbesondere von höchstens 2,0. Bevorzugt werden Polyamide (A1) mit einer Lösungsviskosität ηᵣₑₗ im Bereich von 1,45 bis 2,3, insbesondere im Bereich von 1,5 bis 2,0 oder 1,5 bis 1,8.

Die erfindungsgemäßen Polyamide (A1_1) können auf üblichen Polykondensationsanlagen über die Prozessfolge Vorkondensat und Nachkondensation hergestellt werden. Für die Polykondensation werden zur Regelung der Viskosität bevorzugt die beschriebenen Kettenregler eingesetzt. Zusätzlich kann die Viskosität durch den Einsatz eines Diamin- oder Dicarbonsäureüberschusses eingestellt werden.

Bei den **Polyamiden (A1_2)** sind die Copolyamide 6I/6T, 10I/10T, 12/6T, MXD6/MXDI bevorzugt. Besonders bevorzugt sind die amorphen Copolyamide 6I/6T, 10I/10T und 12/6T mit einem Anteil von weniger als 50 Mol-% 6T- bzw. 10T-Einheiten. Bevorzugt werden insbesondere PA 6I/6T und PA 10I/10T, wobei ein Zusammensetzungsbereich T:I von 20:80 bis 45:55 bevorzugt wird. Im Hinblick auf die Copolyamide MXD6/MXDI werden MXD6 reiche Zusammensetzungen bevorzugt, insbesondere mit einem MXD6-Gehalt von grösser als 80 mol-%, besonders bevorzugt im Bereich von 82 bis 95 mol-%. Die amorphen teilaromatischen Polyamide (A1_2) besitzen bevorzugt eine Lösungsviskosität ηᵣₑₗ, gemessen in m-Kresol (0,5 Gew.-%, 20 °C) im Bereich von 1.3 bis 2,0, bevorzugt im Bereich von 1.4 bis 1,8, insbesondere im Bereich von 1.45 bis 1,75. Die mittels DSC bestimmte Schmelzenthalpie der amorphen Komponenten A1_2 ist maximal 4J/g, bevorzugt kleiner 2 J/g, insbesondere nicht messbar.

Als **aliphatische Polyamide (A1_3)** werden bevorzugt Polyamid 46, Polyamid 6, Polyamid 66, Polyamid 11, Polyamid 12, Polyamid 1212, Polyamid 1010, Polyamid 1012, Polyamid 1112, Polyamid 610, Polyamid 612, Polyamid 69, Polyamid 810 oder deren Gemische, Blends oder Legierungen. Insbesondere werden PA66, PA 1010 und PA12 bevorzugt. Die aliphatischen Polyamide (A1_3) besitzen dabei bevorzugt eine Lösungsviskosität ηᵣₑₗ, gemessen in m-Kresol (0,5 Gew.-%, 20 °C) im Bereich von 1.3 bis 2.3, bevorzugt im Bereich von 1.35 - 2.0, insbesondere im Bereich von 1.40 bis 1.90.

Die genannten Polyamide (A1_3) können aus folgenden Dicarbonsäuren hergestellt werden: Adipinsäure, Korksäure, Azelainsäure, Sebacinsäure, Undecandisäure, Dodecandisäure, Tridecandisäure, Tetradecandisäure, Pentadecandisäure, Hexadecandisäure, Heptadecandisäure, Oktadecandisäure, C36-Dimerfettsäure und Gemischen daraus.

Als Diamine kommen folgende Monomere in Frage: 1,4-Butandiamin, 1,5-Pentandiamin, 2-Methyl-1,5-pentandiamin, 2-Butyl-2-ethyl-1,5-pentandiamin, 1,6-Hexandiamin, 2,2,4-Trimethylhexamethylendiamin, 2,4,4-Trimethylhexamethylendiamin, 1,8-Octandiamin, 2-Methyl-1,8-octandiamin, 1,9-Nonandiamin, 1,10-Decandiamin, 1,11-Undecandiamin, 1,12-Dodecandiamin, 1,13-Tridecandiamin, 1,14-Tetradecandiamin, 1,15-Pentadecandiamin, 1,16-Hexadecandiamin und 1,18-1,14-Octadecandiamin.

Weiterhin können die Polyamide auch aus Lactamen oder Aminocarbonsäuren, insbesondere α,ω-Aminosäuren oder Lactame mit 6 bis 12 Kohlenstoffatome aufgebaut sein, wobei beispielhaft nachfolgende Auswahl genannt sei: Caprolactam (CL), ω-Aminocapronsäure, ω-Aminoheptansäure, ω-Aminoctansäure, ω-Aminononansäure, ω-Aminodecansäure, ω-Aminoundecansäure (AUA), Laurinlactam (LL) und ω-Aminododecansäure (ADA). Besonderes bevorzugt sind Caprolactam, Aminocapronsäure, Laurinlactam und Aminododecansäure.

Bezüglich einer Polymermischung enthaltend die Polyamidkomponenten A1_1 und A1_2, werden folgende Zusammensetzungen bevorzugt:

| | |
|---|---|
| (A1_1): | PA 6T/10T |
| (A1_2): | PA 6I/6T, wobei das Mol-Verhältnis im Bereich von 65:35 bis 75:25 liegt oder insbesondere 67:33 beträgt. |
| (A1_1): | PA 6T/10T/6I; |
| (A1_2): | PA 6I/6T, wobei das Mol-Verhältnis im Bereich von 65:35 bis 75:25 liegt oder insbesondere 67:33 beträgt. |
| (A1_1): | PA 6T/6I, wobei das Mol-Verhältnis im Bereich von 60:40 bis 75:25 liegt; |
| (A1_2): | PA 6I/6T, wobei das Mol-Verhältnis im Bereich von 65:35 bis 75:25 liegt oder insbesondere 67:33 beträgt. |
| (A1_1): | PA6T/10T |
| (A1_2): | PA MXD6/MXDI, wobei im Copolyamid das Mol-Verhältnis im Bereich von 70:30 bis 90:10 liegt oder insbesondere 88:12 beträgt. |

Dabei liegt bevorzugtermassen der Anteil der Komponente (A1_1) jeweils im Bereich von 50 bis 90 Gew.-%, insbesondere von 60 bis 85 Gew.-% und Komponente (A1_2) bevorzugt im Bereich von 10 bis 50 Gew.-%, insbesondere im Bereich von 15 bis 40 Gew.-% jeweils bezogen auf Komponente (A1).

In einer besonderen Ausführungsform werden folgende Zusammensetzungen für die Polymermischung (Polyamidmatrix) bevorzugt:

| | |
|---|---|
| (A1_1): | 55-95 Gew.-% PA 6T/10T, wobei das Mol-Verhältnis im Bereich von 10:90 bis 40:60 liegt; |
| (A1_2): | 5-45 Gew.-% PA 6I/6T, wobei der 6I-Anteil 62-72 mol-% beträgt. |

Des Weiteren enthalten die Formmassen 10 bis 70 Gew.-% der **Komponenten (B)** in Form von Glasfasern (B), die z.B. in Form von sogenannten Kurzfasern (z.B. Schnittglas mit einer Länge von 0.2-20 mm) oder Endlosfasern (Rovings) verwendet werden. Die Glasfasern (B) können unterschiedliche Querschnittsflächen aufweisen, wobei Glasfasern mit kreisförmigem Querschnitt (runde Fasern) und mit nicht-kreisförmigem Querschnitt (flache Fasern) bevorzugt sind.

Glasfaser mit kreisförmigem Querschnitt, also runde Glasfasern, haben einen Durchmesser im Bereich von 5-20 µm, bevorzugt im Bereich von 5-13 µm und besonders bevorzugt im Bereich von 6-10 µm. Sie werden bevorzugt als Kurzglasfaser (Schnittglas mit einer Länge von 0.2 bis 20 mm, bevorzugt 2-12 mm) eingesetzt.

Bei den flachen Glasfasern, also Glasfasern mit nicht-kreisförmiger Querschnittsfläche, werden solche mit einem Abmessungsverhältnis von der Hauptquerschnittsachse zur senkrecht darauf stehenden Nebenquerschnittsachse von mehr als 2.5, bevorzugt im Bereich von 2.5 bis 6, insbesondere im Bereich von 3 bis 5 bevorzugt eingesetzt. Diese sogenannten flachen Glasfasern weisen eine ovale, elliptische, mit Einschnürung(en) versehene elliptische (sogenannte Kokon- oder cocoon-Faser), polygonale, rechteckige oder nahezu rechteckige Querschnittsfläche auf. Ein weiteres kennzeichnendes Merkmal der eingesetzten flachen Glasfasern besteht darin, dass die Länge der Hauptquerschnittsachse bevorzugt im Bereich von 6 bis 40 µm, insbesondere im Bereich von 15 bis 30 µm und die Länge der Nebenquerschnittsachse im Bereich von 3 bis 20 µm, insbesondere im Bereich von 4 bis 10 µm liegt. Dabei weisen die flachen Glasfasern eine möglichst hohe Packungsdichte auf, d.h. die Glasquerschnittsfläche füllt ein gedachtes, den Glasfaserquerschnitt möglichst exakt umgebendes Rechteck zu mindestens 70%, bevorzugt mindestens 80% und insbesondere bevorzugt zu mindestens 85% aus.

Zur Verstärkung der erfindungsgemässen Formmassen können auch Mischungen von Glasfasern mit kreisförmigem und nicht-kreisförmigem Querschnitt verwendet werden, wobei der Anteil an flachen Glasfasern bevorzugtermassen überwiegt, d.h. mehr als 50 Gew.-% der Gesamtmasse der Fasern ausmacht.

Vorzugsweise ist die Komponente (B) ausgewählt aus der Gruppe bestehend aus: E-Glasfasern (diese bestehen gemäss ASTM D578-00 aus 52-62% Siliciumdioxid, 12-16% Aluminiumoxid, 16-25% Calciumoxid, 0-10% Borax, 0-5% Magnesiumoxid, 0-2% Alkalioxide, 0-1.5% Titandioxid und 0-0.3% Eisenoxid; bevorzugt haben sie eine Dichte von 2.58±0.04 g/cm3, einen Zug-E-Modul von 70-75 GPa, eine Zugfestigkeit von 3000-3500 MPa und eine Reissdehnung von 4.5-4.8%), A-Glasfasern (63-72% Siliciumdioxid, 6-10% Calciumoxid, 14-16% Natrium- und Kaliumoxid, 0-6% Aluminiumoxid, 0-6% Boroxid, 0-4% Magnesiumoxid), C-Glasfasern (64-68% Siliciumdioxid, 11-15% Calciumoxid, 7-10% Natrium- und Kaliumoxid, 3-5% Aluminiumoxid, 4-6% Boroxid, 2-4% Magnesiumoxid), D-Glasfasern (72-75% Siliciumdioxid, 0-1% Calciumoxid, 0-4% Natrium- und Kaliumoxid, 0-1% Aluminiumoxid, 21-24% Boroxid), Basaltfasern (Mineralfaser mit der ungefähren Zusammensetzung: 52% SiO₂, 17% Al₂O₃, 9% CaO, 5% MgO, 5% Na₂O, 5% Eisenoxid sowie weiteren Metalloxiden), AR-Glasfasern (55-75% Siliciumdioxid, 1-10% Calciumoxid, 11-21% Natrium- und Kaliumoxid, 0-5% Aluminiumoxid, 0-8% Boroxid, 0-12%Titandioxid, 1-18% Zirkonoxid, 0-5% Eisenoxid) sowie Mischungen davon.

Eine bevorzugte Ausführungsform der Komponente (B) sind hochfeste Glasfasern beruhend auf dem ternären System Siliciumdioxid-Aluminiumoxid-Magnesiumoxid oder auf dem quaternären System Siliciumdioxid-Aluminiumoxid-Magnesiumoxid-Calciumoxid, wobei die Summe der Gehalte von Siliciumdioxid, Aluminiumoxid und Magnesiumoxid wenigstens 78 Gew.-%, bevorzugt wenigstens 87% und besonders bevorzugt wenigstens 92% bezogen auf die gesamte Glaszusammensetzung beträgt. Konkret wird bevorzugt eine Zusammensetzung von 58-70 Gew.-% Siliciumdioxid (SiO2), 15-30 Gew.-% Aluminiumoxid (Al₂O₃), 5-15 Gew.-% Magnesiumoxid (MgO), 0-10 Gew.-% Calciumoxid (CaO) und 0-2 Gew.-% weitere Oxide, wie z.B. Zirkoniumdioxid (ZrO₂), Boroxid (B₂O₃), Titandioxid (TiO₂) oder Lithiumoxid (Li₂O) eingesetzt. In einer weiteren Ausführungsform besitzt die hochfeste Glasfaser eine Zusammensetzung von 60-67 Gew.-% Siliciumdioxid (SiO₂), 20-28 Gew.-% Aluminiumoxid (Al₂O₃), 7-12 Gew.-% Magnesiumoxid (MgO), 0-9 Gew.-% Calciumoxid (CaO) sowie 0-1.5 Gew.-% weitere Oxide, wie z.B. Zirkoniumdioxid (ZrO₂), Boroxid (B₂O₃), Titandioxid (TiO₂), Lithiumoxid (Li₂O).

Insbesondere ist bevorzugt, wenn die hochfeste Glasfaser die nachfolgende Zusammensetzung aufweist: 62-66 Gew.-% Siliciumdioxid (SiO₂), 22-27 Gew.-% Aluminiumoxid (Al₂O₃), 8-12 Gew.-% Magnesiumoxid (MgO), 0- 5Gew.-% Calciumoxid (CaO), 0-1 Gew.-% weitere Oxide, wie z.B. Zirkoniumdioxid (ZrO₂), Boroxid (B₂O₃), Titandioxid (TiO₂), Lithiumoxid (Li₂O).

Die hochfeste Glasfaser besitzt eine Zugfestigkeit von grösser oder gleich 3700 MPa, vorzugsweise von wenigstens 3800 oder 4000 MPa, eine Reissdehnung von mindestens 4.8%, vorzugsweise von wenigstens 4.9 oder 5.0 %, und einen Zug-E-Modul von grösser 75 GPa, vorzugsweise von mehr als 78 oder 80 GPa, wobei diese Glaseigenschaften an Einzelfasern (pristine single filament) mit einem Durchmesser von 10 µm und eine Länge von 12.7 mm bei einer Temperatur von 23°C und einer relativen Luftfeuchte von 50% zu bestimmen sind. Konkrete Beispiele für diese hochfesten Glasfasern der Komponente (B1) sind S-Glasfasern von Owens Corning mit 995-Schlichte, T-Glasfasern von Nittobo, HiPertex von 3B, HS4-Glasfasern von Sinoma Jinjing Fiberglass, R-Glasfasern von Vetrotex sowie S-1- und S-2-Glasfasern von AGY.

Die erfindungsgemäss z.B. als Roving eingesetzten Glasfasern (Endlosfasern) weisen einen Durchmesser (bei runden Glasfasern) bzw. eine Nebenquerschnittsachse (bei flachen Glasfasern) von 8 bis 20 µm, bevorzugt von 12 bis 18 µm auf, wobei der Querschnitt der Glasfasern rund, oval, elliptisch, elliptisch mit Einschnürung(en) versehen, polygonal, rechteckig oder nahezu rechteckig sein kann. Besonders bevorzugt werden sogenannte flache Glasfasern mit einem Verhältnis der Querschnittsachsen, d.h. ein Verhältnis von Haupt- zur Nebenquerschnittsachse von 2.5 bis 5. Die Endlosfasern können aus den oben beschriebenen Glassorten hergestellt sein, wobei Endlosfasern auf Basis von E-Glas und den hochfesten Glassorten bevorzugt sind. Diese Endlosfasern werden in die erfindungsgemässen Polyamidformmassen durch bekannte Verfahren zur Herstellung von langfaserverstärktem Stäbchengranulat eingearbeitet, insbesondere durch Pultrusionsverfahren, bei denen der endlose Faserstrang (Roving) mit der Polymerschmelze vollständig durchtränkt und anschliessend abgekühlt und geschnitten wird. Das auf diese Art und Weise erhaltene langfaserverstärkte Stäbchengranulat, das bevorzugt eine Granulatlänge von 3 bis 25 mm, insbesondere von 4 bis 12 mm aufweist, kann mit den üblichen Verarbeitungsverfahren (wie z. B. Spritzgiessen, Pressen) zu Formteilen weiterverarbeitet werden.

Bevorzugt werden als Komponente (B) Glasfasern aus E-Glas, mit nicht-kreisförmigem Querschnitt (flache Fasern) und mit einem Achsenverhältnis der Hauptquerschnittsachse zur Nebenquerschnittsachse von wenigstens 2.5, und/oder hochfeste Glasfasern mit kreisförmigem oder nicht-kreisförmigem Querschnitt und einer Glaszusammensetzung, beruhend im Wesentlichen auf den Komponenten Siliciumdioxid, Aluminiumoxid und Magnesiumoxid, wobei der Anteil an Magnesiumoxid (MgO) 5-15 Gew.-% und der Anteil an Calciumoxid 0 - 10 Gew.-% beträgt.

Die Glasfasern der Komponente (B) weisen bevorzugt als flache E-Glasfasern eine Dichte von 2.54 - 2.62 g/cm3, einen Zug-E-Modul von 70 - 75 GPa, eine Zugfestigkeit von 3000 - 3500 MPa und eine Reissdehnung von 4.5 - 4.8% auf, wobei die mechanischen Eigenschaften an Einzelfasern mit einem Durchmesser von 10 µm und eine Länge von 12.7 mm bei 23°C und einer relativen Luftfeuchte von 50% bestimmt wurden.

Die erfindungsgemässen Glasfasern können mit einer für Thermoplaste, insbesondere für Polyamid geeigneten Schlichte, enthaltend einen Haftvermittler auf Basis einer Amino- oder Epoxysilanverbindung, versehen sein.

Bevorzugt liegt der Anteil an **Komponente (C)** im Bereich von 0.5-8 Gew.-%, vorzugsweise im Bereich von 1-6 Gew.-% und insbesondere bevorzugt im Bereich von 0.5 - 4.5 Gew.-%.

Die Komponente (C) ist bevorzugt ein LDS-Additiv mit einem von Null verschiedenen Absorptionskoeffizienten für UV-, VIS- oder IR-Strahlung, welches unter Einwirkung von elektromagnetischer Strahlung, bevorzugt als Laserstrahlung, Metallkeime bildet, die in einem chemischen Metallisierverfahren die Abscheidung von Metallschichten zur Erzeugung von Leiterbahnen an den bestrahlten Stellen auf der Formteiloberfläche erleichtern und/oder ermöglichen und/oder verbessern, wobei das LDS-Additiv vorzugsweise eine Absorptionsfähigkeit im sichtbaren und infraroten Strahlungsbereich aufweist mit einem Absorptionskoeffizient von wenigstens 0.05, bevorzugt wenigstens 0.1 und insbesondere wenigstens 0.2, und/oder dass ein Absorber vorgesehen ist, der die Strahlungsenergie auf das LDS-Additiv überträgt.

Die Komponente (C) ist bevorzugt ein LDS-Additiv mit einer mittleren Partikelgrösse (D50) im Bereich von 50 - 20000 Nanometer, bevorzugt 200 bis 15000 Nanometer und besonders bevorzugt 300 bis 5000 Nanometer, und/oder einem Aspektverhältnis von höchstens 10, insbesondere von höchstens 5. Der als Mass für die Partikelgrösse angegebene D50-Wert ist ein Maß für die mittlere Teilchengröße, wobei 50 VolumenProzent der Probe feiner und die anderen 50% der Probe grober sind als der D50-Wert (Median).

In einer bevorzugten Ausführungsform handelt es sich bei Komponente (C) um ein LDS (Laser Direct Structuring)-Additiv ausgewählt aus der Gruppe der Metalloxide, insbesondere sogenannte Spinelle mit der allgemeinen chemischen Formel

AB₂O₄

wobei steht A für ein Metallkation mit der Wertigkeit 2, wobei bevorzugt A ausgewählt ist aus der Gruppe bestehend aus: Magnesium, Kupfer, Kobalt, Zink, Zinn, Eisen, Mangan und Nickel sowie Kombinationen davon;
B für ein Metallkation der Wertigkeit 3, wobei bevorzugt B ausgewählt ist aus der Gruppe bestehend aus: Mangan, Nickel, Kupfer, Kobalt, Zinn, Titan, Eisen, Aluminium und Chrom sowie Kombinationen davon,
wobei insbesondere bevorzugt das LDS-Additiv ein Kupfereisenspinell, ein kupferhaltiges Magnesiumaluminiumoxid ein Kupfer-Chrom-Mangan-Mischoxid, ein Kupfer-Mangan-Eisen-Mischoxid, gegebenenfalls jeweils mit Sauerstofffehlstellen, oder Salze und Oxide des Kupfers, wie insbesondere Kupfer(I)oxid, Kupfer(II)oxid, basische Kupferphosphate, Kupferhydroxylphosphat, Kupfersulfat, sowie Metallkomplexverbindungen, insbesondere Chelatkomplexe von Kupfer, Zinn, Nickel, Cobalt, Silber und Palladium oder Mischungen solcher Systeme, und/oder insbesondere ausgewählt aus der folgenden Gruppe: Kupfer-Chrom-Mangan-Mischoxide, Kupfer-Mangan-Eisen-Mischoxide, Kupferchromoxid, Zink-Eisenoxid, Kobalt-Chromoxid, Kobalt-Aluminiumoxid, Magnesiumaluminiumoxid, sowie Mischungen und/oder oberflächenbehandelte und/oder Sauerstofffehlstellen aufweisende Formen hiervon. Möglich sind z.B. Systeme, wie sie beispielsweise in WO-A-2000/35259 oder in Kunststoffe 92 (2002) 11, 2-7 beschrieben werden.

Weiterhin ist Komponente (C) bevorzugt ausgewählt unter Phosphaten, kondensierten Phosphaten, Phosphonaten, Phosphiten und gemischten Hydroxid-Phosphat-Oxoanionen von Kupfer (Cu), Zinn (Sn), und/oder Eisen (Fe), insbesondere Trizinnphosphat (CAS 15578-32-3), Trikupferphosphat (CAS 7798-23-4), Kupferdiphosphat (CAS 10102-90-6), Kupferhydroxidphosphat (CAS 12158-74-6) und Gemischen davon ausgewählt.

Ebenfalls bevorzugt wird als Komponente (C) ein LDS (Laser Direct Structuring)-Additiv ausgewählt aus der Gruppe der Metalloxide, Metallmischoxide, Metallhydroxidoxide, Metallsulfidoxide auf Basis von Zinn. Besonders bevorzugt ist Zinnoxid und dotiertes Zinnoxid, wobei die Dotierung mit Antimon, Wismut, Molybdän, Aluminium, Titan, Silicium, Eisen, Kupfer, Silber, Palladium und Cobalt erfolgen kann. Insbesondere wird Zinnoxid, das mit Antimon, Titan oder Kupfer dotiert ist, bevorzugt. Weiterhin werden Mischungen aus Zinnoxid und mindestens einem weiteren Metalloxid, insbesondere Antimonoxid als LDS-Additive bevorzugt. Als weiteres Metalloxide werden dabei sowohl farblose hochbrechende Metalloxide, wie insbesondere Titandioxid, Antimon(III)oxid, Zinkoxid, Zinnoxid und/oder Zirkoniumdioxid verwendet als auch farbige Metalloxide wie z.B. Chromoxid, Nickeloxid, Kupferoxid, Kobaltoxid und insbesondere Eisenoxid (Fe₂O₃, Fe₃O₄). Insbesondere bevorzugt wird die Mischung aus Zinnoxid und Antimon(III)oxid verwendet.

Vorzugsweise sind die dotierten Zinnoxide bzw. Metalloxid-Mischungen bzw. Zinnoxid als Schichten auf plättchenförmigen Substraten, insbesondere Schichtsilikaten, wie z.B. synthetischer oder natürlicher Glimmer, Talkum, Kaolin, Glasplättchen oder Siliciumdioxid-Plättchen, ausgebildet. Als Substrat für die Metalloxide werden insbesondere Glimmer bzw. Glimmerschuppen bevorzugt. Weiterhin kommen als Substrate auch plättchenförmige Metalloxide wie z. B. plättchenförmiges Eisenoxid, Aluminiumoxid, Titandioxid, Siliziumdioxid, LCP's (Liquid Crystal Polymers), holographische Pigmente oder beschichtete Graphitplättchen in Betracht.

Besonders bevorzugt werden LDS-Additive auf Basis von Glimmer, wobei die Glimmeroberfläche mit metalldotierten Zinnoxiden beschichtet ist. Insbesondere bevorzugt wird antimondotiertes Zinnoxid. Beispiele für kommerziell erhältliche LDS-Additive gemäss der vorliegenden Erfindung sind: Lazerflair LS820, LS825, LS830 und Minatec 230 A-IR der Firma Merck, Stanostat CP40W, Stanostat CP15G oder Stanostat CP5C der Firma Keeling&Walker.

Somit bevorzugt als Komponente (C) sind LDS-Additive auf Basis von Kupfer und/oder Zinn. Bevorzugt ist Komponente (C) ausgewählt aus der Gruppe bestehend aus Zinnoxid, Metall- oder Metalloxid-dotiertes Zinnoxid, Antimon-dotiertes Zinnoxid, Metalloxidbeschichteter Glimmer, mit Antimon-dotiertem Zinnoxid beschichteter Glimmer, Mischung aus Zinnoxid und Antimonoxid und optional weiterer Metalloxide, Spinelle, Kupferchromoxid, Kupferoxid, Kupferhydroxid, Kupferhydroxidphosphat, Kupferphosphat, basische Kupferphosphate, oder Mischungen und Kombinationen davon. Besonders bevorzugt werden die LDS-Additive (weil sie in Kombination mit dem halogenfreien Flammschutzmittel und der Glasfaserverstärkung zu Formmassen führen, die sehr gute mechanische Eigenschaften aufweisen) basisches Kupferphosphat, Kupferhydroxidphosphat, Kupfer-Zinn-Phosphat, basisches Kupfer-Zinn-Phosphat, Zinnphosphat, basisches Zinnphosphat und antimondotiertes Zinnoxid, wobei Letzteres bevorzugt in Kombination mit Glimmer Verwendung findet. Durch Austausch der auf Spinellen basierten LDS-Additiven, wie z.B. Kupferchromit, durch diese besonders bevorzugten LDS-Additive werden in ansonsten identischen Formmassen die mechanischen Eigenschaften deutlich verbessert. So werden die Reissdehnung und Reissfestigkeit um 10 bis 20% erhöht, Die Schlagzähigkeit und Kerbschlagzähigkeit um 40% und der HDT A um 10% erhöht. Auch die HDT B Werte dieser besonders bevorzugten Formmassen liegen mindestens 5°C höher als die vergleichbaren Spinellbasierten Formmassen.

Die erfindungsgemässen Formmassen enthalten 8 bis 18, bevorzugt 9 bis 16 und besonderes bevorzugt 10 bis 15 Gew.-% eines halogenfreien Flammschutzmittels **(Komponente (D)**). Komponente (D) setzt sich bevorzugt zusammen aus 60-100 Gew.-%, vorzugsweise 70-98 Gew.-%, insbesondere vorzugsweise 80-96 Gew.-% eines phosphorhaltigen Flammschutzmittels, bevorzugt eines Phosphazens, eines Phosphinsäuresalzes und/oder Diphosphinsäuresalzes (Komponente D1) und 0-40 Gew.-%, respektive 2-30 Gew.-%, respektive 4-20 Gew.-% eines stickstoffhaltigen Synergisten und/oder eines Stickstoff und/oder Phosphor enthaltenden Flammschutzmittels (Komponente D2), wobei Letztere vorzugsweise ausgewählt sind aus Melamin oder Kondensationsprodukten des Melamins, wie insbesondere Melem, Melam, Melon, oder Umsetzungsprodukte von Melamin mit Polyphosphorsäure oder Umsetzungsprodukte von Kondensationsprodukten des Melamins mit Polyphosphorsäure oder Gemische davon, insbesondere Melaminpolyphosphat.

Als Komponente (D2) wird insbesondere Melaminpolyphosphat bevorzugt. Derartige Flammschutzmittel sind aus dem Stand der Technik bekannt. Hierzu wird auf die DE 103 46 3261 verwiesen, diesbezüglich sei der Offenbarungsgehalt dieser Schrift ausdrücklich hierin eingeschlossen.

Bevorzugt wird als Komponente (D1) ein Metallsalz der Phosphinsäure und/oder der Diphosphinsäure und/oder deren Polymere, worin das Metallion aus der 2. oder 3. Haupt- oder Nebengruppe des Periodensystems ist und die organischen Reste bevorzugt C1-C10-Alkyl, linear oder verzweigt und/oder Aryl, Alkylen, Arylen, Alkylarylen oder Arylalkylen sind. Als Metallion wird insbesondere Aluminum, Calcium, Barium und Zink bevorzugt. In Kombination mit den Flammschutzkomponenten (D1) und (D2) können gegebenenfalls zusätzlich 0.5 bis 10 Gew.-%, bevorzugt 0.5 bis 5% bezogen auf die Komponente (D), an sauerstoff-, stickstoff- oder schwefelhaltigen Metallverbindungen als sogenannte "Flammschutz-Stabilisatoren" (Komponente (D3)) zugegeben werden. Dabei bevorzugte Metalle sind Aluminium, Calcium, Magnesium und Zink. Geeignete Verbindungen sind ausgewählt aus der Gruppe der Oxide, Hydroxide, Carbonate, Silikate, Borate, Phosphate, Stannate sowie Kombinationen oder Mischungen dieser Verbindungen, wie z.B. Oxid-Hydroxide oder Oxid-Hydroxid-Carbonate. Beispiele sind Magnesiumoxid, Calciumoxid, Aluminiumoxid, Zinkoxid, Magnesiumhydroxid, Aluminiumhydroxid, Böhmit, Dihydrotalcit, Hydrocalumit, Calciumhydroxid, Zinnoxidhydrat, Zinkhydroxid, Zinkborat, Zinksulfid, Zinkphosphat, Zinkcarbonat, Calciumcarbonat, Calciumphosphat, Magnesiumcarbonat, basisches Zinksilikat, Zinkstannat, Calciumstearat, Zinkstearat, Magnesiumstearat, Bariumstearat, Kaliumpalmitat, Magnesiumbehenat. Bei den erfindungsgemässen Kunststoffformassen bzw. bei den daraus hergestellten Formkörpern ist somit weiterhin hervorzuheben, dass in Kombination zu den vorstehend beschriebenen ausgezeichneten Eigenschaften auch ein herausragender Flammschutz erreicht wird. Die Formmasse ist nach UL-Klassifizierung V0 bei 0,8 bis 3.2 mm dicken Probenkörper (UL-94, Prüfung nach den Normen der Underwriters Laboratories (U.L.), vgl. www.ulstandards.com).

Die erfindungsgemässen Copolyamide erreichend die Brandschutzklassierung "V0" auch ohne Synergist-Zusatz (D2). Daher setzt sich die Flammschutzausrüstung bevorzugt ausschliesslich aus den Komponenten D1 und D3 zusammen. Besonders bevorzugt als Flammschutzmittel ist Aluminiumdiethylphosphinat in einem Konzentrationsbereich von 11 bis 16 Gew.-% bezogen auf die gesamte Formmasse, besonders bevorzugt in Kombination mit 0.2 bis 1.0 Gew.-% Melaminpolyphosphat, wobei sich die Mengenangaben jeweils auf die gesamte Formmasse (Summe A bis F) beziehen. Bevorzugt liegt der Anteil an **Komponente (E)** im Bereich von 0-25 Gew.-%, vorzugsweise im Bereich von 0-15 Gew.-% und besonders bevorzugt im Bereich von 2 - 15 Gew.-% oder 3 - 10 Gew-%. Talk, Kreide oder Calciumcarbonat beispielsweise können die Erzeugung von Metallkeimen erleichtern oder die Haftung der Leiterbahnen am Substrat erhöhen.

Als partikuläre Füllstoffe der Komponente (E) kommen alle dem Fachmann bekannten Füllstoffe in Frage. Hierzu zählen insbesondere partikuläre Füllstoffe ausgewählt aus der Gruppe bestehend aus Talk (Magnesiumsilikat), Glimmer, Silikaten, Quarz, Wollastonit, Kaolin, Kieselsäuren, Magnesiumcarbonat, Magnesiumhydroxid, Kreide, gemahlenem oder gefälltem Calciumcarbonat, Kalk, Feldspat, anorganische Pigmente, wie z.B., Eisenoxid oder Eisenmanganoxid oder insbesondere Weisspigmente, wie Bariumsulfat, Zinkoxid, Zinksulfid, Lithopone und Titandioxid (Rutil, Anatas)D, permanentmagnetischen oder magnetisierbaren Metallen oder Legierungen, hohlkugeligen Silikatfüllstoffen, Aluminiumoxid, Bornitrid, Borcarbid, Aluminiumnitrid, Calciumfluorid und Mischungen hiervon. Die Füllstoffe können auch oberflächenbehandelt sein.

Die erfindungsgemässen Formmassen enthalten im Rahmen von Komponente (E) optional 1 bis 10, bevorzugt 1 bis 8 und besonderes bevorzugt 1.5 bis 6 Gew.-% anorganische Weisspigmente bezogen auf die gesamte Formmasse. Komponente (E) kann dabei bevorzugtermassen ausschliesslich aus den anorganischen Weisspigmenten bestehen, ausgewählt aus der Gruppe Bariumsulfat, Zinkoxid, Zinksulfid, Lithopone und Titandioxid (Rutil, Anatas), wobei die Weisspigmente bevorzugtermassen über eine mittlere Partikelgrösse (D50) im Bereich von 0.1-40 µm, bevorzugt im Bereich von 0.1-20 µm, insbesondere im Bereich von 0.1-10 µm verfügen. Besonders bevorzugt wird Zinksulfid. Die als Komponente (E) verwendeten Metalloxide sind verschieden von den Komponenten (C) und (D).

Die Füllstoffe (Komponente E) haben vorzugsweise eine mittlere Partikelgrösse (D50) im Bereich von 0.1-40 µm, bevorzugt im Bereich von 0.2-20 µm, insbesondere im Bereich von 0.3-10 µm. Bevorzugt wird eine Form der partikulären Füllstoffe, bei denen die Aspektverhältnisse L/b1 und L/b2 beide höchstens 10, insbesondere höchstens 5 sind, wobei die Aspektverhältnisse durch die Quotienten aus grösster Länge L des Teilchens zu dessen mittleren Breite b1 oder b2 beschrieben werden. Dabei liegen b1 und b2, die senkrecht zueinander angeordnet sind, in einer zur Länge L senkrechten Ebene.

Natürlich können die erfindungsgemäßen thermoplastischen Polyamidformmassen im Rahmen von **Komponente (F)** weiterhin übliche und dem Fachmann allgemein bekannte Zusatzstoffe in Form der Additive (F) enthalten, die bevorzugt aus der Gruppe bestehend aus: Haftvermittlern, Stabilisatoren, Alterungsschutzmitteln, Antioxidantien, Antiozonantien, Lichtschutzmitteln, UV-Stabilisatoren, UV-Absorbern, UV-Blockern, anorganischen Hitzestabilisatoren, insbesondere auf Basis von Kupferhalogeniden und Alkalihalogeniden, organischen Hitzestabilisatoren, Leitfähigkeitsadditiven, Russ, optischen Aufhellern, Verarbeitungshilfsmitteln, Nukleierungsmitteln, Kristallisationsbeschleunigern, Kristallisationsverzögerern, Fliesshilfsmitteln, Gleitmitteln, Entformungsmitteln, Weichmachern, Pigmenten, insbesondere organische Pigmente, Farbstoffen verschieden von Komponente (D) Markierungsstoffen und Mischungen hiervon ausgewählt sind.

Des Weiteren betrifft die Erfindung ein Bauteil (Formteil), insbesondere Bauteil mit elektrischen Leiterbahnen, auf Basis einer Formmasse wie oben dargestellt. Einsatzgebiete für die MID-Technologie sind der Automobilbau, die Industrieautomation, die Medizintechnik, die Hausgeräteindustrie, Unterhaltungselektronik, die Telekommunikationstechnik, die Mess- und Analysetechnik, Maschinenbau, sowie Luft- und Raumfahrt. Die Erfindung betrifft damit auch indirekt einen Artikel, insbesondere einen Schaltungsträger, enthaltend ein Formteil, hergestellt aus der erfindungsgemässen Formmasse. In einer Ausführungsform wird der Schaltungsträger genutzt, um eine Antenne auszubilden.

Solche Formteile sind beispielsweise Gehäuse oder Gehäuseteile für tragbare elektronische, wie z.B. PDAs, Mobiltelefone, andere Telekommunikations-Geräte, Gehäuse oder Gehäuseteile für Personal Computer, Notebooks, medizinische Geräte, wie z.B. Hörgeräte, Sensortechnik, oder RFID (Radio Frequency IDentification) Transponder oder Teile für den Automobilbereich, wie z.B. Airbagmodul, Multifunktionslenkrad. Aufgrund der umfangreichen Gestaltungsmöglichkeiten beim Kunststoffspritzgiessen können dreidimensionale Schaltungsträger realisiert werden. Darüber hinaus können typische mechanische Funktionen wie Halter, Führungen, Taster, Stecker oder andere Verbindungselemente integriert werden. Ebenfalls möglich sind Konnektoren für E/E und für Kraftstoffsysteme. Weitere Ausführungsformen sind in den abhängigen Ansprüchen angegeben.

Weitere Ausführungsformen sind in den abhängigen Ansprüchen angegeben.

### BESCHREIBUNG BEVORZUGTER AUSFÜHRUNGSFORMEN

Die Erfindung soll nachfolgend unter Verwendung von spezifischen Ausführungsbeispielen (B) beschrieben und mit den weniger leistungsfähigen Systemen nach dem Stand der Technik (VB) verglichen werden. Die in der Folge angegebenen Ausführungsbeispiele dienen zur Stützung der Erfindung und zum Nachweis der Unterschiede zum Stand der Technik, sie sollen aber nicht zur Einschränkung des allgemeinen Gegenstandes der Erfindung, wie er in den Patentansprüchen definiert ist, hinzugezogen werden.

### Beispiele B1 bis B14 und Vergleichsbeispiele VB1 bis VB5

Die in den Tabellen 2 bis 4 angegebenen Komponenten werden in einem zweiwelligen Extruder der Firma Werner und Pfleiderer mit einem Schneckendurchmesser von 25 mm bei vorgegebenen Prozessparametern (Tabelle 1) compoundiert. Dabei werden die Polyamidgranulate sowie die Zusatzstoffe in die Einzugszone dosiert, während die Glasfaser über einen Sidefeeder 3 Gehäuseeinheiten vor der Düse in die Polymerschmelze dosiert wird. Die Granulierung erfolgte mittels einer Unterwassergranulierung bzw. Heißabschlags unter Wasser, bei der die Polymerschmelze durch eine Lochdüse gedrückt und direkt nach dem Austritt aus der Düse von einem rotierenden Messer in einem Wasserstrom granuliert wird. Nach Granulierung und Trocknung bei 120°C für 24h wurden die Granulateigenschaften gemessen und die Prüfkörper hergestellt.

Die Compounds werden mit einer Spritzgussmaschine Arburg Allrounder 320-210-750 zu Probekörpern bei definierten Zylindertemperaturen der Zonen 1 bis 4 und einer definierten Werkzeugtemperatur (siehe Tabelle 1) verspritzt.

**Tabelle 1: Compoundier- und Spritzgussbedingungen für die Beispiele und Vergleichsbeispiele**

| **Compoundier**-/**Verarbeitungsparameter** | | **B1-B14, VB1** -**VB5** |
|---|---|---|
| Compoundierung | Zylindertemperaturen [°C] | 300 - 350 |
| | Schneckendrehzahl [Upm] | 180 |
| | Durchsatz [kg/h] | 8 |
| Spritzguss | Zylindertemperaturen [°C] | 320 - 340 |
| | Werkzeugtemperatur [°C] | 80 |

**Tabelle 2: Zusammensetzung und Eigenschaften der Beispiele B1 bis B7**

| | Einheit | **B1** | **B2** | **B3** | **B4** | **B5** | **B6** | **B7** |
|---|---|---|---|---|---|---|---|---|
| PA 6T/10T (15:85) | Gew.-% | 39.85 | 39.85 | 38.0 | 59.85 | 53.0 | 39.85 | 39.85 |
| PA 6T/6I (70:30) | Gew.-% | | | | | | | |
| PA 6I/6T (70:30) | Gew.-% | 20 | 20 | 10 | | | 20 | 20 |
| Glasfaser Typ A | Gew.-% | 20 | | 30 | 20 | 30 | 20 | 20 |
| Glasfaser Typ B | Gew.-% | | 20 | | | | | |
| LDS-Additiv 1 | Gew.-% | 4 | 4 | 4 | 4 | 4 | | |
| LDS-Additiv 2 | Gew.-% | | | | | | 4 | |
| LDS-Additiv 3 | Gew.-% | | | | | | | 4 |
| FSM-1 | Gew.-% | 15 | 15 | 12 | 15 | 12 | 15 | 15 |
| FSM-2 | Gew.-% | 0.65 | 0.65 | 0.5 | 0.65 | 0.5 | 0.65 | 0.65 |
| Weisspigment | Gew.-% | | | 5.0 | | | | |
| STAB | Gew.-% | 0.5 | 0.5 | 0.5 | 0.5 | 0.5 | 0.5 | 0.5 |
| Zug-E-Modul | MPa | 8500 | 8800 | 11200 | 8700 | 11000 | 8600 | 8500 |
| Reissfestigkeit | MPa | 112 | 117 | 120 | 113 | 127 | 130 | 127 |
| Reissdehnung | % | 2.0 | 2.2 | 2.0 | 2.1 | 2.1 | 2.3 | 2.3 |
| Schlagzähigkeit 23°C | kJ/m² | 35 | 44 | 32 | 40 | 35 | 48 | 52 |
| Kerbschlagzähigkeit 23°C | kJ/m² | 5.1 | 7.5 | 5.5 | 6.2 | 5.2 | 7.2 | 7.5 |
| HDT A (1.8 MPa) | °C | 205 | 212 | 231 | 245 | 255 | 224 | 225 |
| HDT B (0.45 MPa) | °C | 263 | 264 | 275 | >280 | >280 | 269 | 268 |
| Glanz | | 95 | 95 | 90 | 80 | 75 | 94 | 95 |
| Metallisierbarkeit | | ++ | ++ | ++ | + | + | ++ | ++ |
| UL94 | | | | | | | | |
| 2d Normklima | | V0 | V0 | V0 | V0 | V0 | V0 | V0 |
| 7d 70°C | | V0 | V0 | V0 | V0 | V0 | V0 | V0 |
| Lötbarkeit (Plattendicke ohne Blister) | mm | 1.7 | 1.7 | 1.2 | 1.7 | 1.2 | 1.7 | 1.7 |

**Tabelle 3: Zusammensetzung und Eigenschaften der Vergleichsbeispiele VB1 bis VB5**

| | Einheit | **VB1** | **VB2** | **VB3** | **VB4** | **VB5** | |
|---|---|---|---|---|---|---|---|
| ***Zusammensetzung*** | | | | | | | |
| PA 6T/10T | Gew.-% | | 57 | 67 | 65.5 | 65.5 | |
| PA 6I/6T (30:70) | Gew.-% | 57 | | | | | |
| PA 6I/6T (70:30) | Gew.-% | | | | | | |
| Glasfaser Typ A | Gew.-% | 30 | 30 | 20 | 30 | | |
| Glasfaser Typ B | Gew.-% | | | | | 30 | |
| LDS-Additiv 1 | Gew.-% | | | | 4 | 4 | |
| LDS-Additiv 2 | Gew.-% | | | | | | |
| FSM-1 | Gew.-% | 12 | 12 | 15 | | | |
| FSM-2 | Gew.-% | 0.5 | 0.5 | 0.5 | | | |
| STAB | Gew.-% | 0.5 | 0.5 | 0.5 | 0.5 | 0.5 | |

| ***Eigenschaften*** | | | | | | | |
|---|---|---|---|---|---|---|---|
| Zug-E-Modul | MPa | 10800 | 9600 | 8600 | 10800 | 11000 | |
| Reissfestigkeit | MPa | 121 | 128 | 113 | 140 | 145 | |
| Reissdehnung | % | 1.6 | 1.9 | 2.1 | 1.8 | 2.0 | |
| Schlagzähigkeit 23°C | kJ/m² | 43 | 47 | 37 | 32 | 40 | |
| Kerbschlagzähigkeit 23°C | kJ/m² | 5.3 | 7.6 | 7.1 | 7.8 | 8.3 | |
| HDT A (1.8 MPa) | °C | 260 | 258 | 247 | 248 | 249 | |
| HDT B (0.45 MPa) | °C | >280 | >280 | >280 | >280 | >280 | |
| Glanz | | 70 | 74 | 78 | 76 | 78 | |
| Metallisierbarkeit | | - | - | - | + | + | |
| UL94 | | | | | | | |
| 2d Normklima | | V0 | V0 | V0 | HB | HB | |
| 7d 70°C | | V0 | V0 | V0 | HB | HB | |
| Lötbarkeit (Plattendicke ohne Blister) | mm | 1.2 | 1.2 | 1.7 | 1.2 | 1.2 | |

**Tabelle 4: Zusammensetzung und Eigenschaften der Beispiele B8 bis B14**

| | Einheit | **B8** | **B9** | **B10** | **B11** | **B12** | **B13** | **B14** |
|---|---|---|---|---|---|---|---|---|
| PA 6T/10T (15:85) | Gew.-% | 49.85 | | 69.85 | 33 | 33 | 40 | 40 |
| PA 6I/6T (30:70) | Gew.-% | | 49.85 | | | | | |
| PA 6I/6T (70:30) | Gew.-% | 10 | 10 | | | | | 20 |
| PPE Typ A | Gew.-% | | | | 20 | 20 | 20 | |
| Glasfaser Typ A | Gew.-% | | | | | | 20 | |
| Glasfaser Typ B | Gew.-% | 20 | 20 | 10 | 30 | 30 | | |
| Glasfaser Typ C | Gew.-% | | | | | | | 20 |
| LDS-Additiv 1 | Gew.-% | | | 4 | | | 4 | 4 |
| LDS-Additiv 2 | Gew.-% | 4 | 4 | | 4 | | | |
| LDS-Additiv 3 | Gew.-% | | | | | 4 | | |
| FSM-1 | Gew.-% | 15 | 15 | 15 | 12 | 12 | 15 | 15 |
| FSM-2 | Gew.-% | 0.65 | 0.65 | 0.65 | 0.5 | 0.5 | 0.5 | 0.5 |
| STAB | Gew.-% | 0.5 | 0.5 | 0.5 | 0.5 | 0.5 | 0.5 | 0.5 |
| Zug-E-Modul | MPa | 8500 | 8800 | 5700 | 10200 | 10300 | 8500 | 9000 |
| Reissfestigkeit | MPa | 118 | 110 | 98 | 148 | 146 | 108 | 132 |
| Reissdehnung | % | 2.3 | 2.0 | 2.7 | 2.3 | 2.4 | 2.0 | 2.3 |
| Schlagzähigkeit 23°C | kJ/m² | 48 | 35 | 33 | 48 | 44 | 35 | 41 |
| Kerbschlagzähigkeit 23°C | kJ/m² | 7.8 | 6.1 | 5.5 | 8.0 | 7.8 | 5.7 | 6.3 |
| HDT A (1.8 MPa) | °C | 232 | 234 | 174 | 231 | 230 | 200 | 180 |
| HDT B (0.45 MPa) | °C | 273 | 273 | 269 | 270 | 270 | 255 | 257 |
| Glanz 85° | | 92 | 88 | 82 | 94 | 94 | 90 | 94 |
| Metallisierbarkeit | - | ++ | ++ | + | ++ | ++ | ++ | ++ |
| UL94 | | | | | | | | |
| 2d Normklima | - | V0 | V0 | V0 | V0 | V0 | V0 | V0 |
| 7d 70°C | - | V0 | V0 | V0 | V0 | V0 | V0 | V0 |
| Lötbarkeit (Plattendicke ohne Blister) | mm | 1.7 | 1.7 | 1.7 | 1.2 | 1.2 | 1.2 | 1.7 |

### Legende, Materialien:

| | |
|---|---|
| PA 6I/6T (70:30) | Amorphes, teilaromatisches Polyamid auf Basis von Terephthalsäure (30 mol-%), Isophthalsäure (70 mol-%) und 1,6-Hexandiamin, mit einer Glasübergangstemperatur von 125°C und einer Lösungsviskosität von 1.54. |
| PA 6I/6T (30:70) | Teilkristallines, teilaromatisches Polyamid auf Basis von Terephthalsäure (70 mol-%), Isophthalsäure (30 mol-%) und 1,6-Hexandiamin, mit einer Schmelzpunk von 325°C und einer Lösungsviskosität von 1.58. |
| PA 6T/10T | Teilkristallines, teilaromatisches Polyamid auf Basis von 1,6-Hexandiamin (15 mol-%), 1,10-Decandiamin (85 mol-%) und Terephthalsäure, mit einem Schmelzpunkt von 305°C und einer Lösungsviskosität von 1.62. |
| PPE Typ A | Bondyram 6008, Maleinsäureanhydrid-modifiziertes PPE, Polyram |
| Glasfaser Typ A | CPIC ECS 301 HP, 3 mm lang, 10 µm Durchmesser, CPIC, China. (Glasfasern mit kreisförmigem Querschnitt) |
| Glasfaser Typ B | CPIC ECS 301 T, 3 mm lang, 24 µm breit, 8 µm dick, Aspektverhältnis der Querschnittsachsen = 3, CPIC, China (Flache Glasfaser) |
| Glasfaser Typ C: | HPXSS PAX95 10-4, 4 mm lang, 10 µm Durchmesser, Owens Corning Vetrotex, France, (Glasfasern mit kreisförmigem Querschnitt) |
| LDS-Additiv 1 | Shepherd Schwarz 30C965 (The Shepherd Color Company), Kupferchromit (CuCr₂O₄), mittlere Partikelgrösse von 0.6 µm. |
| LDS-Additiv 2 | Fabulase 322 S, Kupfer(II)hydroxydphosphat, Budenheim |
| LDS-Additiv 3 | Fabulase 330, Metallphosphat auf Zinnbasis, Budenheim |
| Weisspigment | Titandioxid KRONOS 2222, White pigment. >92.5% titanium dioxide. Rutile. Coating: Al, Si, polysiloxane. d₅₀ 0.21µm. D4.0g/cm³. |
| FSM-1 | Exolit®OP1230, phosphororganisches Salz (Clariant Produkte GmbH), Flammschutzmittel |
| FSM-2 | Melapur 200/70, Melaminpolyphosphat (BASF) |

Die Messungen wurden nach folgenden Normen und an folgenden Prüfkörpern durchgeführt.

### (Thermo-) Mechanische Parameter:

Der Zug-E-Modul wurde nach ISO 527 mit einer Zuggeschwindigkeit von 1 mm/min, die Streckspannung, die Reissfestigkeit und die Reissdehnung wurden bestimmt gemäss ISO 527 mit einer Zuggeschwindigkeit von 50 mm/min (unverstärkte Varianten) oder einer Zuggeschwindigkeit von 5 mm/min (verstärkte Varianten) bei einer Temperatur von 23 °C, wobei als Probekörper ein ISO-Zugstab, Norm: ISO/CD 3167, Typ Al, 170 x 20/10 x 4 mm, verwendet wurde.

Schlagzähigkeit und Kerbschlagzähigkeit nach Charpy wurden nach ISO 179 am ISO-Prüfstab, Norm: ISO/CD 3167, Typ B1, 80 x 10 x 4 mm bei Temperatur 23 °C gemessen. Das thermische Verhalten (Schmelztemperatur (Tₘ), Schmelzenthalpie (ΔHₘ), Glasumwandlungstemperatur (Tg)) wurde anhand der ISO-Norm 11357-11-2 am Granulat bestimmt. Die Differential Scanning Calorimetry (DSC) wurde mit Aufheizrate von 20 °C/min durchgeführt. Für die Glasumwandlungstemperatur (Tg) wird die Temperatur für die Mittelstufe bzw. den Wendepunkt angegeben.

Die relative Viskosität (ηᵣₑₗ) wurde gemäss DIN EN ISO 307 anhand von 0,5 Gew.-%-igen m-Kresollösungen bei 20 °C gemessen. Als Probe wird Granulat verwendet.

Die Wärmeformbeständigkeit in Form von HDT A (1,8 MPa) und HDT B (0.45 MPa) wurden gemäss ISO 75 an ISO-Schlagstäben der Dimension 80x10x4 mm bestimmt.

### Oberflächeneigenschaften, Glanz:

Der Glanz wurde an Platten der Dimension 80x80x1mm mit einem Gerät des Typs Minolta Multi Gloss 268 unter einem Winkel von 85° und bei einer Temperatur von 23°C nach ISO 2813 bestimmt.

### Las rstrukturierbarkeit:

Zur Beurteilung des Metallisierungsverhaltens wurden spritzgegossene Formteile (Platte 60 x 60 x 2 mm) mit Hilfe eines Nd:YAG-Lasers strukturiert und nachfolgend stromlos im Verkupferungsbad metallisiert. Bei der Laserstrukturierung wurden auf der Formteiloberfläche 18 nebeneinanderliegende, 5 x 7 mm grosse Bereiche bestrahlt. Die Laserstrukturierung erfolgte mittels eines LPKF Microline 3D Lasers bei einer Wellenlänge von 1064 nm und einer Bestrahlungsbreite von circa 50 µm bei einer Geschwindigkeit von 4 m/s. Dabei wurde sowohl die Pulsfrequenz als auch die Leistung des Lasers variiert. Für die konkreten Pulsfrequenzen von 60, 80 und 100 kHz wurde die Leistung jeweils im Bereich von 3 - 17 Watt variiert. Im Anschluss an die Laserstrukturierung werden die Formteile einem Reinigungsprozess zur Entfernung der Rückstände des Laserprozesses unterworfen. Die Formteile durchlaufen dabei nacheinander Ultraschallbäder mit Tensid und deionisiertem Wasser. Die gereinigten Formteile werden sodann in einem reduktiven Verkupferungsbad (MacDermid MID-Copper 100 B1) für 60 - 80 Minuten metallisiert. Dabei scheidet sich auf den vom Laser bestrahlten Flächen Kupfer in einer durchschnittlichen Dicke von 3 bis 5 µm ab.

### Metallisierbarkeit:

Der Metallisierbarkeit wurde optisch wie folgt beurteilt:
++: alle 18 Felder werden jeweils gleichmässig metallisiert und die abgeschiedene Kupferschicht hat eine durchschnittliche Dicke von 3 bis 5 µm.
+: 15 - 17 Felder, werden jeweils gleichmässig metallisiert und die abgeschiedene Kupferschicht hat eine durchschnittliche Dicke von 3 bis 5 µm (Felder strukturiert bei minimaler Energie werden ungenügend metallisiert).
o: 12 - 14 Felder werden jeweils gleichmässig metallisiert und die abgeschiedene Kupferschicht hat eine durchschnittliche Dicke von 3 bis 5 µm.
-: Weniger als 12 Felder werden jeweils gleichmässig metallisiert und die abgeschiedene Kupferschicht hat eine durchschnittliche Dicke von 3 bis 5 µm bzw. unstrukturierte Bereiche (ohne Bestrahlung) wurden metallisiert.

Die chemisch-reduktive Kupferabscheidung ist bei allen moulded interconnect device (MID)-Technologien der entscheidende Startmetallisierungsprozess, der über die Qualität der Gesamtschicht entscheidet. Deshalb ist es völlig ausreichend, die Qualität der Primärmetallschicht zu beurteilen. Um zum fertigen MID-Teil zu kommen, werden aufbauend auf der ersten Kupferschicht (Primärschicht) in der Regel Nickel und anschliessend eine Endschicht aus Tauchgold abgeschieden. Selbstverständlich können auch andere Metallschichten, wie z.B. weitere Kupfer-, Palladium-, Zinn- oder Silberschichten auf die Primärschicht aufgebracht werden.

### Lötbarkeit:

Es werden Stufenplatten folgender Abmessungen im Spritzgussverfahren hergestellt: Länge x Breite 60x60 dabei ist die Plattenhöhe in 5 treppenartigen Stufen wie folgt ausgeführt: 1.2mm, 1.7mm, 2.2mm, 2.7mm und 3.2mm. Dabei sind die Treppenstufen 60mm breit und 12mm tief. Diese Stufenplatten werden bei 85°C und 85% relativer Feuchte für 168 Stunden in einem Klimaschrank Allen 600 der Firma Angelantoni Industrie s.p.a. (IT) konditioniert wie es in dem Joint Industry Standard IPC/JEDEC J-STD-020D.1 für den Feuchtigkeitssensitivitätslevel 1 (Moisture Sensitivity Level, SML 1) beschrieben ist. Danach werden jeweils 3 Stufenplatten auf eine Platine gelegt (einseitige Temperaturbelastung) und mit einer Bandgeschwindigkeit von 200 mm/min durch ein Reflow Lötsystem RO300FC der Firma Essemtec AG (CH) transportiert. Die Heizzonen werden auf die in der Tabelle 5 aufgeführten Temperaturen eingestellt. Bei Prüfung 2 (einseitig) ergibt sich für die 1.7mm dicke Plattenstufe das vorgeschriebene Lötprofil mit einer Peaktemperatur von 260°C. Die Oberflächentemperatur bei der Stufe mit 1.7mm Dicke ist 54 sec über 255°C und 22 sec über 260°C. Als Ergebnis der Lötprüfung wurde die Dicke der Prüfplattenstufe ohne Blister als minimale Wandstärke bestimmt und in die Tabellen 2 bis 4 eingetragen.

VB1 bis VB3 haben zwar ausreichende mechanische Eigenschaften, erreichen die Brandschutzklassifizierung V0 und sind im Reflowprozess lötbar, sind aber nicht metallisierbar. Dagegen können VB4 und VB5 gut metallisiert werden, erfüllen aber nicht die Brandschutzanforderung gemäss UL94.

Formteile, hergestellt aus den Formmassen der Beispiele B1 bis B14 dagegen weisen gute mechanische Eigenschaften und eine hohe Oberflächengüte (Glanz) auf, sind sicher im Reflow-Lötprozess lötbar und erreichen die Brandschutzklassifizierung V0 gemäss UL94.

## Patentansprüche

1. Thermoplastische Formmasse bestehend aus:
(A) 21 - 81.9 Gew.-% thermoplastischem Kunststoff, bestehend aus
(A1) 55 - 100 Gew.-% Polyamid, enthaltend wenigstens 50 Gew.-% teilaromatisches, teilkristallines Polyamid;
(A2) 0 - 45 Gew.-% thermoplastischer Kunststoff nicht auf Polyamidbasis (A2_1), ein davon verschiedener Schlagzähmodifier (A2_2), oder Mischungen davon, wobei, wenn der thermoplastische Kunststoff nicht auf Polyamidbasis (A2_1) und der davon verschiedene Schlagzähmodifier (A2_2) zusammen verwendet werden, das Verhältnis (A2_1 : A2_2) von thermoplastischem Kunststoff nicht auf Polyamidbasis (A2_1) zu davon verschiedenem Schlagzähmodifier (A2_2) wenigstens 1:1 beträgt;
wobei sich (A1) und (A2) zu 100 Gew.-% Komponente (A) ergänzen;
(B) 10 - 70 Gew.-% Glasfasern;
(C) 0,1 - 10 Gew.-% LDS-Additiv oder einer Mischung von LDS-Additiven;
(D) 8 - 18 Gew.-% halogenfreies Flammschutzmittel;
(E) 0 - 40 Gew.-% partikulärer Füllstoff, verschieden von (C);
(F) 0 - 2 Gew.-% weitere andere Additive;
wobei die Summe aus (A) - (F) 100 Gew.-% ausmacht.

2. Formmasse nach Anspruch 1, **dadurch gekennzeichnet, dass** die Komponente (A2) ausgewählt ist aus der Gruppe bestehend aus: Polycarbonat, Polyphenylenoxid, Polyphenylenether, Polystyrol, Polymethylmethacrylat, Acrylnitril-Butadien-Styrol-Copolymerisat, Acrylnitril-Styrol-Copolymer, Polyolefin, Polyoxymethylen, Polyester, insbesondere Polyethylenterephthalat, Polybutylenterephthalat, Polysulfon, insbesondere des Typs PSU, PESU, PPSU, Polyphenylensulfid, flüssigkristalline Polymere, Polyetherketon, Polyetheretherketon, Polyimid, Polyesterimid, Polyurethan, insbesondere des Typs TPU, PUR, Polysiloxan, Polyacrylat, Polymethacrylat sowie Mischungen oder Copolymere auf Basis solcher Systeme
und/oder dass der Anteil der Komponente (A2) innerhalb der 100 Gew.-% der Komponente (A), im Bereich von 5-40 Gew.-% liegt, vorzugsweise im Bereich von 5-30 Gew.-% oder im Bereich von 10-35 Gew.-%.

3. Formmasse einem der vorhergehenden Ansprüche, **dadurch gekennzeichnet, dass** die Komponente (A1) aus einer Mischung von teilkristallinem teilaromatischem Polyamid (A1_1) und amorphem, teilaromatischem Polyamid (A1_2) und/oder aliphatischem Polyamid (A1_3) besteht.

4. Formmasse einem der vorhergehenden Ansprüche, **dadurch gekennzeichnet, dass** die Komponente (A1) ganz aus teilkristallinem teilaromatischem Polyamid besteht oder aus einer Polyamidmischung (A1), welche mindestens 60 Gew.-%, bevorzugt mindestens 65 Gew.-%, jeweils innerhalb der 100 Gew.-% der Komponente (A), teilkristallines teilaromatisches Polyamid enthält,
und/oder das teilkristalline, teilaromatische Polyamide der Komponente (A1) über eine mittels DSC bestimmte Schmelzenthalpie (ISO-Norm 11357-11-2) im Bereich von 25 bis 80 J/g, vorzugsweise im Bereich von 30 bis 70 J/g verfügt.

5. Formmasse nach einem der vorhergehenden Ansprüche, **dadurch gekennzeichnet, dass** der Anteil an Komponente (A) im Bereich von 25-75.5 Gew.-% liegt, vorzugsweise im Bereich von 30-71 Gew.-%, jeweils bezogen auf die Summe aus (A) - (F).

6. Formmasse nach einem der vorhergehenden Ansprüche, **dadurch gekennzeichnet, dass** der Anteil an Komponente (B) im Bereich von 15-60 Gew.-% liegt, vorzugsweise im Bereich von 18-55 Gew.-%, oder im Bereich von 18-42 Gew.-%, oder im Bereich von 20-45 Gew.-%, oder im Bereich von 20-35 Gew.-%, jeweils bezogen auf die Summe aus (A) - (F).

7. Formmasse nach einem der vorhergehenden Ansprüche, **dadurch gekennzeichnet, dass** die Glasfasern der Komponente (B) als E-Glasfasern gemäss ASTM D578-00, vorzugsweise mit nicht-kreisförmigem Querschnitt, ausgewählt sind, vorzugsweise aus 52-62% Siliciumdioxid, 12-16% Aluminiumoxid, 16-25% Calciumoxid, 0-10% Borax, 0-5% Magnesiumoxid, 0-2% Alkalioxide, 0-1.5% Titandioxid und 0-0.3% Eisenoxid, oder als hochfeste Glasfasern, vorzugsweise mit nicht-kreisförmigem Querschnitt, beruhend auf dem ternären System Siliciumdioxid-Aluminiumoxid-Magnesiumoxid oder auf dem quaternären System Siliciumdioxid-Aluminiumoxid-Magnesiumoxid-Calciumoxid, wobei sie bevorzugtermassen die folgende Zusammensetzung aufweisen: 58-70 Gew.-%, bevorzugt 60-67 Gew.-% Siliciumdioxid (SiO₂), 15-30 Gew.-%, bevorzugt 20-28 Gew.-% Aluminiumoxid (Al₂O₃), 5-15 Gew.-%, bevorzugt 7-12 Gew.-% Magnesiumoxid (MgO), 0-10 Gew.-%, bevorzugt 0-9 Gew.-% Calciumoxid (CaO) und 0-2 Gew.-%, bevorzugt 0-1.5 Gew.-% weitere Oxide, wie insbesondere Zirkoniumdioxid (ZrO₂), Boroxid (B₂O₃), Titandioxid (TiO₂) oder Lithiumoxid (Li₂O) oder eine Kombination dieser Oxide, ausgewählt sind.

8. Formmasse nach einem der vorhergehenden Ansprüche, **dadurch gekennzeichnet, dass** die Glasfasern der Komponente (B) Glasfasern mit nicht-kreisförmiger Querschnittsfläche sind, wobei das Abmessungsverhältnis von der Hauptquerschnittsachse zur senkrecht darauf stehenden Nebenquerschnittsachse mehr als 2.5 ist, bevorzugt im Bereich von 2.5 bis 6, insbesondere bevorzugt im Bereich von 3 bis 5 liegt.

9. Formmasse nach einem der vorhergehenden Ansprüche, **dadurch gekennzeichnet, dass** der Anteil an Komponente (C) im Bereich von 0.5-8 Gew.-% liegt, vorzugsweise im Bereich von 1-6 Gew.-%, jeweils bezogen auf die Summe aus (A) - (F).

10. Formmasse nach einem der vorhergehenden Ansprüche, **dadurch gekennzeichnet, dass** Komponente (C) mindestens ein LDS-Additiv enthält oder ganz gebildet wird durch ein LDS-Additiv ausgewählt aus der folgenden Gruppe: Metalloxid, Metallphosphat, vorzugsweise basisches Metallphosphat und/oder Metallhydroxidphosphat,
und/oder dass Komponente (C) mindestens ein LDS-Additiv enthält oder ganz gebildet wird durch ein LDS-Additiv, das eine anorganische Verbindung auf Basis des Kupfers und/oder Zinns ist,
wobei vorzugsweise Komponente (C) mindestens ein LDS-Additiv enthält oder ganz gebildet wird durch ein LDS-Additiv ausgewählt aus der folgenden Gruppe: Zinnoxid; Metall- oder Metalloxid-dotiertes Zinnoxid; Antimon-dotiertes Zinnoxid; Metalloxidbeschichteter Glimmer; mit Antimon-dotiertem Zinnoxid beschichteter Glimmer; Mischung aus Zinnoxid und Antimonoxid und optional weiterer Metalloxide; Spinelle; Kupferchromoxid; Kupferoxid; Kupferhydroxid; Kupferhydroxidphosphat; Kupferphosphat; basische Kupferphosphate; Kupfer-Zinn-Phosphat; basisches Kupfer-Zinn-Phosphat; Zinnphosphat; basisches Zinnphosphat; antimondotiertes Zinnoxid, bevorzugt in Kombination mit Glimmer ; oder Mischungen und Kombinationen davon.

11. Formmasse nach einem der vorhergehenden Ansprüche, **dadurch gekennzeichnet, dass** der Anteil an Komponente (D) im Bereich von 11-17 Gew.-% liegt, vorzugsweise im Bereich von 12-16 Gew.-%, besonders bevorzugt im Bereich vom 13 - 16 Gew.-%, jeweils bezogen auf die Summe aus (A) - (F).

12. Formmasse nach einem der vorhergehenden Ansprüche, **dadurch gekennzeichnet, dass** das halogenfreie Flammschutzmittel (D) ein phosphorbasiertes Flammschutzmittel ist, wobei es vorzugsweise mindestens eine Spezies ausgewählt aus einem Reaktionsprodukt von Melamin mit Phosphorsäure, (Di)phosphinatsalz und einer Phosphazenverbindung enthält.

13. Formmasse nach einem der vorhergehenden Ansprüche, **dadurch gekennzeichnet, dass** Komponente (D) besteht aus:
(D1) 60-100 Gew.-% eines oder mehrerer Phosphinsäuresalze und/oder Diphosphinsäuresalze, wobei das Metallion unabhängig ausgeählt sein kann aus der Gruppe bestehend aus: Aluminium, Calcium, Barium, Zink oder Kombinationen davon;
(D2) 0-30 Gew.-% eines stickstoffhaltigen Synergisten und/oder eines Stickstoff und/oder Phosphor enthaltenden Flammschutzmittels, vorzugsweise ausgewählt aus der Gruppe bestehend aus Melamin oder Kondensationsprodukten des Melamins, bevorzugt Melem, Melam, Melon, oder Umsetzungsprodukte von Melamin mit Polyphosphorsäure oder Umsetzungsprodukte von Kondensationsprodukten des Melamins mit Polyphosphorsäure oder Gemische davon, besonders bevorzugt Melaminpolyphosphat;
(D3) 0-10 Gew.-% Flammschutz-Stabilisatoren, bevorzugt Zinkborat, Bariumstearat,
wobei sich (D1), (D2) und (D3) zu 100 Gew.-% Komponente (D) ergänzen.

14. Formmasse nach einem der vorhergehenden Ansprüche, **dadurch gekennzeichnet, dass** der Anteil an Komponente (E) im Bereich von 0-25 Gew.-% liegt, vorzugsweise im Bereich von 0-15 Gew.-%, besonders bevorzugt im Bereich vom 2 - 15 Gew.-% oder 3 - 10 Gew.-%, jeweils bezogen auf die Summe aus (A) - (F).

15. Bauteil, insbesondere Bauteil mit elektrischen Leiterbahnen, auf Basis einer Formmasse nach einem der vorhergehenden Ansprüche, bevorzugt als Gehäuse oder Gehäuseteil für tragbare elektronische Geräte, wie insbesondere PDAs, Mobiltelefone, Telekommunikations-Geräte, Gehäuse oder Gehäuseteile für Personal Computer, Notebooks, medizinische Geräte, wie insbesondere Hörgeräte, Sensortechnik, oder RFID Transponder oder Teile für den Automobilbereich, wie insbesondere Airbagmodul, Multifunktionslenkrad.

## Claims

1. Thermoplastic moulding compound consisting of:
(A) 21-81.9 wt.% thermoplastic material, consisting of
(A1) 55-100 wt.% polyamide, containing at least 50 wt.% partly aromatic, partly crystalline polyamide;
(A2) 0-45 wt.% non-polyamide based thermoplastic material (A2_1), an impact modifier (A2_2) different therefrom, or mixtures thereof, wherein, if said non-polyamide-based thermoplastic material (A2_1) and said impact modifier (A2_2) different therefrom are used together, the ratio (A2_1 : A2_2) of said non-polyamide-based thermoplastic material (A2_1) to said impact modifier (A2_2) different therefrom is at least 1:1;
wherein (A1) and (A2) add up to 100 wt.% component (A);
(B) 10-70 wt.% glass fibres;
(C) 0.1-10 wt.% LDS additive or a mixture of LDS additives;
(D) 8-18 wt.% halogen-free flame retardant;
(E) 0-40 wt.% particulate filler, different from (C);
(F) 0-2 wt.% other further additives;
wherein the sum of (A)-(F) makes up 100 wt.%.

2. Moulding compound according to Claim 1, **characterized in that** the component (A2) is selected from the group consisting of: polycarbonate, polyphenylene oxide, polyphenylene ether, polystyrene, polymethyl methacrylate, acrylonitrile-butadiene-styrene copolymer, acrylonitrile-styrene copolymer, polyolefin, polyoxymethylene, polyesters, in particular polyethylene terephthalate and polybutylene terephthalate, polysulphone, in particular of the PSU, PESU or PPSU type, polyphenylene sulphide, liquid crystalline polymers, polyether ketone, polyether ether ketone, polyimide, polyester imide, polyurethane, in particular of the TPU or PUR type, polysiloxane, polyacrylate, polymethacrylate and mixtures or copolymers based on such systems
and/or that the content of the component (A2) within the 100 wt.% of component (A) lies in the range from 5-40 wt.%, preferably in the range from 5-30 wt.% or in the range from 10-35 wt.%.

3. Moulding compound according to one of the previous claims, **characterized in that** the component (A1) consists of a mixture of partly crystalline partly aromatic polyamide (A1_1) and amorphous, partly aromatic polyamide (A1_2) and/or aliphatic polyamide (A1_3).

4. Moulding compound according to one of the previous claims, **characterized in that** the component (A1) consists entirely of partly crystalline partly aromatic polyamide or of a polyamide mixture (A1) which contains at least 60 wt.%, preferably at least 65 wt.%, partly crystalline partly aromatic polyamide, each within the 100 wt.% of component (A),
and/or the partly crystalline, partly aromatic polyamide of component (A1) has a melting enthalpy determined by DSC (ISO Standard 11357-11-2) in the range from 25 to 80 J/g, preferably in the range from 30 to 70 J/g.

5. Moulding compound according to one of the previous claims, **characterized in that** the content of component (A) lies in the range from 25-75.5 wt.%, preferably in the range from 30-71 wt.%, each based on the sum of (A)-(F).

6. Moulding compound according to one of the previous claims, **characterized in that** the content of component (B) lies in the range from 15-60 wt.%, preferably in the range from 18-55 wt.%, or in the range from 18-42 wt.%, or in the range from 20-45 wt.%, or in the range from 20-35 wt.%, each based on the sum of (A)-(F).

7. Moulding compound according to one of the previous claims, **characterized in that** the glass fibres of component (B) are selected as E-glass fibres according to ASTM D578-00, preferably with non-circular cross section, preferably of 52-62% silicon dioxide, 12-16% aluminium oxide, 16-25% calcium oxide, 0-10% borax, 0-5% magnesium oxide, 0-2% alkali metal oxides, 0-1.5% titanium dioxide and 0-0.3% iron oxide, or are selected as high-strength glass fibres, preferably with non-circular cross section, based on the ternary system silicon dioxide-aluminium oxide-magnesium oxide or on the quaternary system silicon dioxide-aluminium oxide-magnesium oxide-calcium oxide, wherein they preferably have the following composition: 58-70 wt.%, preferably 60-67 wt.% silicon dioxide (SiO₂), 15-30 wt.%, preferably 20-28 wt.% aluminium oxide (Al₂O₃), 5-15 wt.%, preferably 7-12 wt.% magnesium oxide (MgO), 0-10 wt.%, preferably 0-9 wt.% calcium oxide (CaO) and 0-2 wt.%, preferably 0-1.5 wt.% further oxides, such as in particular zirconium dioxide (ZrO₂), boron oxide (B₂O₃), titanium dioxide (TiO₂) or lithium oxide (Li₂O) or a combination of these oxides.

8. Moulding compound according to one of the previous claims, **characterized in that** the glass fibres of component (B) are glass fibres with non-circular cross section, wherein the dimension ratio of the major cross-sectional axis to the minor cross-sectional axis lying perpendicular thereto is more than 2.5, preferably in the range from 2.5 to 6, and particularly preferably lies in the range from 3 to 5.

9. Moulding compound according to one of the previous claims, **characterized in that** the content of component (C) lies in the range from 0.5-8 wt.%, preferably in the range from 1-6 wt.%, each based on the sum of (A)-(F).

10. Moulding compound according to one of the previous claims, **characterized in that** component (C) contains at least one LDS additive or is entirely formed by an LDS additive selected from the following group: metal oxide, metal phosphate, preferably basic metal phosphate and/or metal hydroxide phosphate,
and/or that component (C) contains at least one LDS additive or is entirely formed by an LDS additive which is an inorganic compound based on copper and/or tin, wherein component (C) preferably contains at least one LDS additive or is entirely formed by an LDS additive selected from the following group: tin oxide; metal- or metal oxide-doped tin oxide; antimony-doped tin oxide; metal oxide-coated mica; mica coated with antimony-doped tin oxide; mixture of tin oxide and antimony oxide and optionally further metal oxides; spinels; copper-chromium oxide; copper oxide; copper hydroxide; copper hydroxide phosphate; copper phosphate; basic copper phosphate; copper-tin phosphate; basic copper-tin phosphate; tin phosphate; basic tin phosphate; antimony-doped tin oxide, preferably in combination with mica; or mixtures and combinations thereof.

11. Moulding compound according to one of the previous claims, **characterized in that** the content of component (D) lies in the range from 11-17 wt.%, preferably in the range from 12-16 wt.%, particularly preferably in the range from 13-16 wt.%, each based on the sum of (A)-(F).

12. Moulding compound according to one of the previous claims, **characterized in that** the halogen-free flame retardant (D) is a phosphorus-based flame retardant, wherein it preferably contains at least one species selected from a reaction product of melamine with phosphoric acid, (di)phosphinate salt and a phosphazene compound.

13. Moulding compound according to one of the previous claims, **characterized in that** component (D) consists of:
(D1) 60-100 wt.% of one or more phosphinic acid salts and/or diphosphinic acid salts, wherein the metal ion can be independently selected from the group consisting of: aluminium, calcium, barium, zinc or combinations thereof;
(D2) 0-30 wt.% of a nitrogen-containing synergist and/or of a nitrogen and/or phosphorus-containing flame retardant, preferably selected from the group consisting of melamine or condensation products of melamine, preferably melem, melam, melon, or reaction products of melamine with polyphosphoric acid or reaction products of condensation products of melamine with polyphosphoric acid or mixtures thereof, particularly preferably melamine polyphosphate;
(D3) 0-10 wt.% flame retardancy stabilizers, preferably zinc borate or barium stearate,
wherein (D1), (D2) and (D3) add up to 100 wt.% component (D).

14. Moulding compound according to one of the previous claims, **characterized in that** the content of component (E) lies in the range from 0-25 wt.%, preferably in the range from 0-15 wt.%, particularly preferably in the range from 2-15 wt.% or 3-10 wt.%, each based on the sum of (A)-(F).

15. Component, in particular component with electrical conducting tracks, based on a moulding compound according to one of the previous claims, preferably as housing or housing part for wearable electronic devices, such as in particular PDAs, mobile telephones, telecommunication devices, housing or housing parts for personal computers, notebooks, medical devices, such as in particular hearing aids, sensor technology, or RFID transponders or parts for the automobile sector, such as in particular airbag module or multifunction steering wheel.

## Revendications

1. Masse de moulage thermoplastique, constituée par
(A) 21-81,9% en poids de matériau thermoplastique, constitué par
(A1) 55-100% en poids de polyamide, contenant au moins 50% en poids de polyamide partiellement cristallin, partiellement aromatique ;
(A2) 0-45% en poids de matériau thermoplastique, qui n'est pas à base de polyamide,
(A2_1) un agent de modification de la résilience (A2_2) différent du matériau thermoplastique qui n'est pas à base de polyamide,
(A2_1) ou des mélanges de ceux-ci;
dans lesquels, lorsque le matériau thermoplastique, qui n'est pas à base de polyamide (A2_1) et l'agent de modification de la résilience (A2_2) sont utilisés ensemble, le rapport (A2_1 : A2_2) du matériau thermoplastique, qui n'est pas à base de polyamide (A2_1) à l'agent de modification de la résilience (A2_2) est d'au moins 1:1
(A1) et (A2) se complétant à 100% en poids de composant (A) ;
(B) 10-70% en poids de fibres de verre ;
(C) 0,1-10% en poids d'additif LDS (Laser Direct Structuration - structuration directe par laser) ou d'un mélange d'additifs LDS ;
(D) 8-18% en poids d'agent ignifuge exempt d'halogène ;
(E) 0-40% en poids de charge particulaire, différente de (C) ;
(F) 0-2% en poids d'autres additifs ;
la somme de (A) à (F) valant 100% en poids.

2. Masse de moulage selon la revendication 1, **caractérisée en ce que** le composant (A2) est choisi dans le groupe constitué par : polycarbonate, poly(oxyde de phénylène), polyphénylénéther, polystyrène, poly((méth)acrylate de méthyle), copolymère d'acrylonitrile-butadiène-styrène, copolymère d'acrylonitrile-styrène, polyoléfine, polyoxyméthylène, polyester, en particulier poly(téréphtalate d'éthylène), poly(téréphtalate de butylène), polysulfone, en particulier du type PSU, PESU, PPSU, poly(sulfure de phénylène), polymères à cristaux liquides, polyéthercétone, polyétheréthercétone, polyimide, polyesterimide, polyuréthane, en particulier du type TPU, PUR, polysiloxane, polyacrylate, polyméthacrylate ainsi que les mélanges ou les copolymères à base de ces systèmes, et/ou **en ce que** la proportion du composant (A2) dans les 100% en poids de composant (A) se situe dans la plage de 5-40% en poids, de préférence dans la plage de 5-30% en poids ou dans la plage de 10-35% en poids.

3. Masse de moulage selon l'une quelconque des revendications précédentes, **caractérisée en ce que** le composant (A1) est constitué par un mélange de polyamide partiellement cristallin, partiellement aromatique (A1_1) et de polyamide partiellement aromatique, amorphe (A1_2) et/ou de polyamide aliphatique (A1_3).

4. Masse de moulage selon l'une quelconque des revendications précédentes, **caractérisée en ce que** le composant (A1) est constitué totalement de polyamide partiellement aromatique, partiellement cristallin ou par un mélange de polyamides (A1), qui contient au moins 60% en poids, de préférence au moins 65% en poids, à chaque fois dans les 100% en poids du composant (A), de polyamide partiellement aromatique, partiellement cristallin,
et/ou **en ce que** le polyamide partiellement aromatique, partiellement cristallin du composant (A1) dispose d'une enthalpie de fusion déterminée par DSC (differential scanning calorimetry - calorimétrie à balayage différentiel) (norme ISO 11357-11-2) dans la plage de 25 à 80 J/g, de préférence dans la plage de 30 à 70 J/g.

5. Masse de moulage selon l'une quelconque des revendications précédentes, **caractérisée en ce que** la proportion de composant (A) se situe dans la plage de 25-75,5% en poids, de préférence dans la plage de 30-71% en poids, à chaque fois par rapport à la somme de (A) - (F) .

6. Masse de moulage selon l'une quelconque des revendications précédentes, **caractérisée en ce que** la proportion de composant (B) se situe dans la plage de 15-60% en poids, de préférence dans la plage de 18-55% en poids ou dans la plage de 18-42% en poids, ou dans la plage de 20-45% en poids ou dans la plage de 20-35% en poids, à chaque fois par rapport à la somme de (A)-(F) .

7. Masse de moulage selon l'une quelconque des revendications précédentes, **caractérisée en ce que** les fibres de verre du composant (B) sont choisies en tant que fibres de verre de type E selon la norme ASTM D578-00, présentant de préférence une section non circulaire, de préférence constituées par 52-62% de dioxyde de silicium, 12-16% d'oxyde d'aluminium, 16-25% d'oxyde de calcium, 0-10% de borax, 0-5% d'oxyde magnésium, 0-2% d'oxydes de métal alcalin, 0-1,5% de dioxyde de titane et 0-0,3% de dioxyde de fer, ou en tant que fibres de verre hautement résistantes, présentant de préférence une section non circulaire, à base du système ternaire dioxyde de silicium-oxyde d'aluminium-oxyde de magnésium ou du système quaternaire dioxyde de silicium-oxyde d'aluminium-oxyde de magnésium-oxyde de calcium, les fibres présentant de préférence la composition suivante : 58-70% en poids, de préférence 60-67% en poids de dioxyde de silicium (SiO₂), 15-30% en poids, de préférence 20-28% en poids d'oxyde d'aluminium (Al₂O₃) , 5-15% en poids, de préférence 7-12% en poids d'oxyde de magnésium (MgO), 0-10% en poids, de préférence 0-9% en poids d'oxyde de calcium (CaO) et 0-2% en poids, de préférence 0-1,5% en poids d'autres oxydes, tels qu'en particulier le dioxyde de zirconium (ZrO₂), l'oxyde de bore (B₂O₃), le dioxyde de titane (TiO₂) ou l'oxyde de lithium (Li₂O) ou une combinaison de ces oxydes.

8. Masse de moulage selon l'une quelconque des revendications précédentes, **caractérisée en ce que** les fibres de verre du composant (B) sont des fibres de verre présentant une section transversale non circulaire, le rapport des dimensions de l'axe transversal principal à l'axe transversal secondaire perpendiculaire à celui-ci étant supérieur à 2,5 et se situant de préférence dans la plage de 2,5 à 6, de manière particulièrement préférée dans la plage de 3 à 5.

9. Masse de moulage selon l'une quelconque des revendications précédentes, **caractérisée en ce que** la proportion de composant (C) se situe dans la plage de 0,5-8% en poids, de préférence dans la plage de 1-6% en poids, à chaque fois par rapport à la somme de (A)-(F).

10. Masse de moulage selon l'une quelconque des revendications précédentes, **caractérisée en ce que** le composant (C) contient au moins un additif LDS ou est formé dans sa totalité par un additif LDS choisi dans le groupe suivant : oxyde métallique, phosphate métallique, de préférence phosphate métallique basique et/ou phosphate d'hydroxyde métallique,
et/ou **en ce que** le composant (C) contient au moins un additif LDS ou est formé totalement par un additif LDS qui est un composé inorganique à base de cuivre et/ou d'étain,
le composant (C) contenant de préférence au moins un additif LDS ou étant formé totalement par un additif LDS choisi dans le groupe suivant : oxyde d'étain ; oxyde d'étain dopé par un métal ou un oxyde métallique ; oxyde d'étain dopé par de l'antimoine ; mica revêtu d'oxyde métallique ; mica revêtu d'oxyde d'étain dopé par de l'antimoine ; mélange d'oxyde d'étain et d'oxyde d'antimoine et éventuellement d'autres oxydes métalliques ; spinelle ; oxyde de cuivre et de chrome ; oxyde de cuivre ; hydroxyde de cuivre ; phosphate d'hydroxyde de cuivre ; phosphate de cuivre ; phosphates de cuivre basiques ; phosphate de cuivre-étain ; phosphate de cuivre-étain basique ; phosphate d'étain ; phosphate d'étain basique ; oxyde d'étain dopé par de l'antimoine, de préférence en combinaison avec du mica ; ou des mélanges et des combinaisons de ceux-ci.

11. Masse de moulage selon l'une quelconque des revendications précédentes, **caractérisée en ce que** la proportion de composant (D) se situe dans la plage de 11-17% en poids, de préférence dans la plage de 12-16% en poids, de manière particulièrement préférée dans la plage de 13-16% en poids, à chaque fois par rapport à la somme de (A)-(F).

12. Masse de moulage selon l'une quelconque des revendications précédentes, **caractérisée en ce que** l'agent ignifuge exempt d'halogène (D) est un agent ignifuge à base de phosphore, l'agent contenant de préférence au moins une substance choisie parmi un produit de réaction de la mélamine avec de l'acide phosphorique, un sel de (di)phosphinate et un composé de phosphazène.

13. Masse de moulage selon l'une quelconque des revendications précédentes, **caractérisée en ce que** le composant (D) est constitué par :
(D1) 60-100% en poids d'un ou de plusieurs sels de l'acide phosphinique et/ou de l'acide diphosphinique, l'ion métallique pouvant être choisi indépendamment dans le groupe constitué par : l'aluminium, le calcium, le baryum, le zinc ou des combinaisons de ceux-ci ;
(D2) 0-30% en poids d'un synergiste contenant de l'azote et/ou d'un agent ignifuge contenant de l'azote et/ou du phosphore, de préférence choisi dans le groupe constitué par la mélamine ou des produits de condensation de la mélamine, de préférence le mélem, le mélam, le mélon, ou des produits de transformation de la mélamine avec de l'acide polyphosphorique ou des produits de transformation de produits de condensation de la mélamine avec de l'acide polyphosphorique ou des mélanges de ceux-ci, de manière particulièrement préférée le polyphosphate de mélamine ;
(D3) 0-10% en poids de stabilisant de l'agent ignifuge, de préférence le borate de zinc, le stéarate de baryum, (D1), (D2) et (D3) se complétant à 100% en poids de composant (D).

14. Masse de moulage selon l'une quelconque des revendications précédentes, **caractérisée en ce que** la proportion de composant (E) se situe dans la plage de 0-25% en poids, de préférence dans la plage de 0-15% en poids, de manière particulièrement préférée dans la plage de 2-15% en poids ou de 3-10% en poids, à chaque fois par rapport à la somme de (A)-(F).

15. Pièce, en particulier pièce présentant des pistes conductrices électriques, à base d'une masse de moulage selon l'une quelconque des revendications précédentes, de préférence sous forme de boîtier ou de partie de boîtier pour des appareils électroniques portables, tels qu'en particulier des organiseurs (PDA), des téléphones mobiles, des appareils de télécommunications ; de boîtiers ou de parties de boîtier pour des ordinateurs personnels, des ordinateurs portables ; des appareils médicaux, tels qu'en particulier des appareils auditifs ; la technique de capteurs ou des transpondeurs RFID ; ou des pièces pour le domaine automobile, telles qu'en particulier un module d'airbag, un volant multifonction.
